# EUROPEAN PATENT APPLICATION

(11) **EP 4 583 677 A1**
(43) Date of publication of application: **09.07.2025**
(21) Application number: 24223884.8
(22) Date of filing: 31.12.2024
(51) Int. Cl.: H10K 59/35, H10K 59/38

(54) **DISPLAY PANEL AND MANUFACTURING METHOD OF THE SAME**

(30) Priority: 04.01.2024 KR 20240001512
(71) Applicant: Samsung Display Co., Ltd., Yongin-si, Gyeonggi-do 17113 (KR)
(72) Inventor: LEE, Seon Uk, Giheung-Gu, Yongin-si, Gyeonggi-Do (KR); KIM, Kanguk, Giheung-Gu, Yongin-si, Gyeonggi-Do (KR)
(74) Representative: Dr. Weitzel & Partner

(57) **Abstract**

A display panel includes a display element layer including a light-emitting element and an optical structure layer. The optical structure layer includes a light control layer including a bank including a first bank opening and a first light control pattern disposed in the first bank opening, and a color filter layer including a first color filter disposed in a first filter region. A first bank region defined by the first bank opening includes a first sub-region having a first width and a first length, and a second sub-region having a second width greater than the first width. The first filter region overlaps the first sub-region and a portion of the second sub-region. A width of the first filter region is smaller than or substantially equal to the first width, and a length of the first filter region is greater than or substantially equal to the first length.

## Description

### BACKGROUND

The present invention relates to a display panel and a method of manufacturing the same, and more particularly, to a display panel and a method of manufacturing the same with increased resolution and improved manufacturing process efficiency.

A display panel includes a transmissive display panel that selectively transmits source light generated from a light source and a light-emitting display panel that itself generates source light. The display panel may include different types of light control patterns depending on pixels in order to generate a color image. The light control patterns may transmit source light of only some wavelength ranges or change the color of source light. Some light control patterns may change the characteristics of light without changing the color of source light.

### SUMMARY

The invention provides a display panel capable of implementing high resolution and with improved manufacturing process efficiency.

The invention also provides a method of manufacturing a display panel with improved manufacturing process efficiency.

The invention is defined by the features of the independent claims. The dependent claims describe preferred embodiments.

An embodiment of the invention provides a display panel including a display element layer including a light-emitting element that outputs source light and an optical structure layer that is disposed on the light-emitting element and transmits the source light or converts the source light into light of a different wavelength. The optical structure layer includes a light control layer disposed above the light-emitting element and including a bank including a first bank opening and a first light control pattern disposed in the first bank opening; and a color filter layer disposed above the light control layer and including a first color filter disposed in a first filter region. A first bank region defined by the first bank opening includes a first sub-region having a first width in a first direction and a first length in a second direction intersecting the first direction; and a second sub-region having a second width greater than the first width in the first direction. The first filter region overlaps the first sub-region and a portion of the second sub-region. A width of the first filter region in the first direction is smaller than or at least substantially equal (or equal) to the first width, and a length of the first filter region in the second direction is greater than or at least substantially equal (or equal) to the first length.

In an embodiment, the bank may further include a second bank opening spaced apart from the first bank opening and a third bank opening spaced apart from each of the first bank opening and the second bank opening. The light control layer may further include a second light control pattern disposed in the second bank opening and a third light control pattern disposed in the third bank opening.

In an embodiment, a second bank region defined by the second bank opening may include a third sub-region having a third width in the first direction and a second length in the second direction; and a fourth sub-region having a fourth width in the first direction. The fourth width may be larger than the third width.

In an embodiment, a third bank region may be defined by the third bank opening. Widths of the first sub-region, the third sub-region, and the third bank region in the first direction may be at least substantially equal (or equal) to each other.

In an embodiment, the first bank region, the second bank region, and the third bank region may be sequentially arranged in the first direction. The first sub-region and the third sub-region may be spaced apart from each other by a first separation distance in the first direction, the third sub-region and the third bank region may be spaced apart from each other by a second separation distance in the first direction. The first separation distance and the second separation distance may be at least substantially equal (or equal) to each other.

In an embodiment, the color filter layer may further include a second color filter disposed in a second filter region spaced apart from the first filter region and a third color filter disposed in a third filter region spaced apart from the first filter region and the second filter region.

In an embodiment, the second filter region may overlap the third sub-region and a portion of the fourth sub-region. A width of the second filter region in the first direction may be smaller than or at least substantially equal (or equal) to the third width, and a length of the second filter region in the second direction may be greater than or at least substantially equal (or equal) to the second length.

In an embodiment, widths of the first filter region, the second filter region, and the third filter region in the first direction may be at least substantially equal (or equal) to each other. A length of the first filter region in the second direction may be greater than a length of the second filter region in the second direction. A length of the second filter region in the second direction may be greater than a length of the third filter region in the second direction.

In an embodiment, the second length may be shorter than the first length.

In an embodiment, a third bank region may be defined by the third bank opening. The third bank region may have a rectangular shape on a plane.

In an embodiment, a second bank region is defined by the second bank opening. A length of the third bank region in the second direction may be shorter than a length of each of the first bank region and the second bank region in the second direction.

In an embodiment, the first light control pattern may include a first quantum dot that converts the source light into light of a first wavelength. The second light control pattern may include a second quantum dot that converts the source light into light of a second wavelength.

In an embodiment, the third light control pattern may include a photosensitive resin.

In an embodiment, the display panel may further include a circuit element layer including a pixel circuit electrically connected to the light-emitting element. The light-emitting element may include a first electrode disposed on the circuit element layer, an intermediate layer disposed on the first electrode and including a light-emitting layer, and a second electrode disposed on the intermediate layer. The display element layer may further include an auxiliary electrode disposed on the circuit element layer and electrically connected to the second electrode. At least a portion of a connection region in which the auxiliary electrode may be disposed may overlap the second sub-region on a plane.

In an embodiment, the first sub-region may include a (1-1)-th side and a (1-2)-th side extending in the second direction and spaced apart from each other in the first direction. The second sub-region may include a (2-1)-th side and a (2-2)-th side extending in the second direction and spaced apart from each other in the first direction. The (1-2)-th side and the (2-2)-th side may be aligned with each other on a same straight line in the second direction.

In an embodiment, the second sub-region may include a first chamfered portion recessed toward the inside of the second sub-region from the (2-1)-th side of the second sub-region.

In an embodiment, the first filter region may include a first sub-filter region overlapping the first sub-region and a second sub-filter region overlapping the second sub-region. A width of the second sub-filter region in the first direction may be greater than a width of the first sub-filter region in the first direction.

In an embodiment, the display element layer may be divided into a display region in which the light-emitting element is disposed and a non-display region surrounding at least a portion of the display region. The first bank region may include a (1-1)-th bank region disposed in the display region and a (1-2)-th bank region disposed in the non-display region.

In an embodiment of the invention, a display panel includes a light-emitting element that outputs source light; and an optical structure layer disposed on the light-emitting element and transmitting the source light or converting the source light into light of a different wavelength. The optical structure layer includes a light control layer including a bank disposed on the light-emitting element and having a first bank opening, a second bank opening, and a third bank opening, a first light control pattern disposed in the first bank opening, a second light control pattern disposed in the second bank opening, and a third light control pattern disposed in the third bank opening; and a color filter layer disposed on the light control layer and including a first color filter overlapping the first light control pattern, a second color filter overlapping the second light control pattern, and a third color filter overlapping the third light control pattern. A first bank region defined by the first bank opening includes a first sub-region having a first width in a first direction; and a second sub-region having a second width in the first direction. A second bank region defined by the second bank opening includes a third sub-region having a third width in the first direction; and a fourth sub-region having a fourth width in the first direction. The second width is greater than the first width, and the fourth width is greater than the third width. A third bank region is defined by the third bank opening. Widths of the first sub-region, the third sub-region, and the third bank region in the first direction are at least substantially equal (or equal) to each other.

In an embodiment of the invention, a method of manufacturing a display panel includes preparing a display element layer including a light-emitting element that outputs source light; and forming an optical structure layer on the light-emitting element. The forming of the optical structure layer includes forming a bank in which a first bank opening, a second bank opening, and a third bank opening are formed above the light-emitting element; patterning a photoresist material in the third bank opening to form a third light control pattern; and forming each of a first light control pattern and a second light control pattern through an inkjet process in each of the first bank opening and the second bank opening. A first bank region defined by the first bank opening includes a first sub-region having a first width in a first direction; and a second sub-region having a second width in the first direction. A second bank region defined by the second bank opening includes a third sub-region having a third width in the first direction; and a fourth sub-region having a fourth width in the first direction. The second width is greater than the first width, and the fourth width is greater than the third width.

The technical objectives to be achieved by the invention are not limited to those described herein, and other technical objectives that are not mentioned herein would be clearly understood by a person skilled in the art from the description of the invention.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1A is a schematic perspective view of a display panel according to an embodiment of the invention;
FIG. 1B is a schematic cross-sectional view of the display panel according to an embodiment of the invention;
FIG. 1C is a schematic plan view of the display panel according to an embodiment of the invention;
FIG. 2 is a schematic enlarged plan view of a portion of the display panel according to an embodiment of the invention;
FIG. 3 is a schematic cross-sectional view of a portion of the display panel according to an embodiment of the invention;
FIGS. 4A to 4D are schematic cross-sectional views of a portion of the display panel according to an embodiment of the invention;
FIG. 5 is a schematic cross-sectional view of a light-emitting element according to an embodiment of the invention;
FIG. 6A is a schematic enlarged plan view of a portion of the display panel according to an embodiment of the invention;
FIG. 6B is a schematic enlarged plan view of a portion of the display panel according to an embodiment of the invention;
FIG. 7 is a schematic cross-sectional view of a portion of the display panel according to an embodiment of the invention;
Each of FIGS. 8A to 8D is a schematic enlarged plan view of a portion of the display panel according to an embodiment of the invention;
FIG. 9 is a schematic enlarged plan view of a portion of the display panel according to an embodiment of the invention; and
FIGS. 10A to 10D are schematic cross-sectional views illustrating some steps of a method of manufacturing a display panel according to an embodiment of the invention.

### DETAILED DESCRIPTION OF THE EMBODIMENTS

Hereinafter, embodiments of the invention will be described with reference to the drawings.

In this specification, it will be understood that when an element (or region, layer, portion, etc.) is referred to as being "on", "connected to" or "coupled to" another element, it can be directly on, connected or coupled to the other element, or intervening elements may be present between them.

Like reference numerals or characters refer to like elements throughout. In addition, in the drawings, the thicknesses, ratios, and dimensions of elements may be exaggerated for effective description of the technical contents. As used herein, the term "and/or" includes any and all combinations that the associated configurations can define.

It will be understood that, although the terms first, second, etc. may be used herein to describe various elements, these elements should not be limited by these terms. These terms are only used to distinguish one element from another element. For example, a first element could be termed a second element without departing from the scope of the invention. Similarly, the second element may also be referred to as the first element. The terms of a singular form include plural forms unless otherwise specified.

In addition, terms, such as "below", "lower", "above", "upper" and the like, are used herein for ease of description to describe one element's relation to another element(s) as illustrated in the figures. The above terms are relative concepts and are described based on the directions indicated in the drawings.

It will be understood that the terms "comprise", "include", and/or "have", when used in this specification, specify the presence of stated features, integers, steps, operations, elements, components and/or groups thereof, but do not preclude the presence or addition of one or more other features, integers, steps, operations, elements, components, and/or groups thereof.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

The term "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display panel and a method of manufacturing the display panel according to an embodiment of the invention will be described with reference to the drawings.

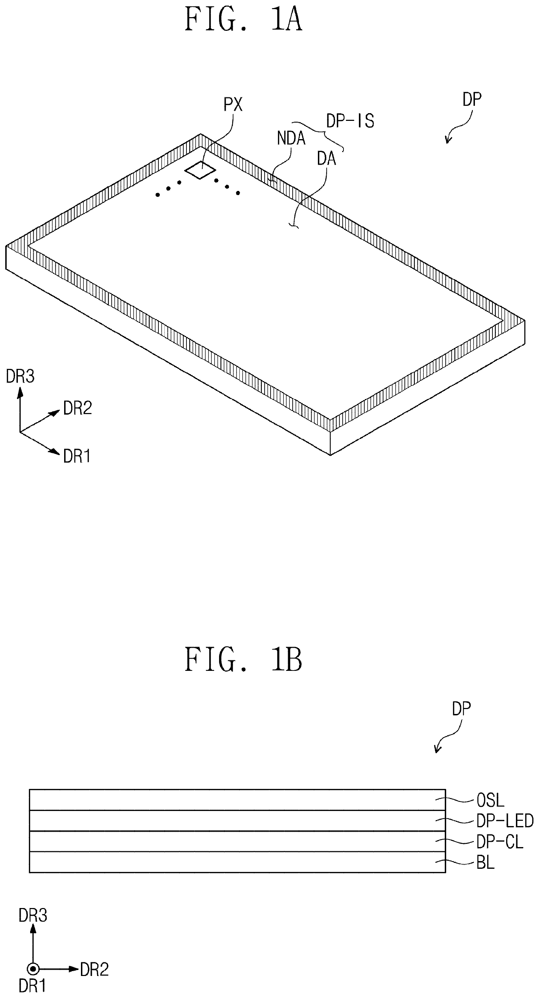

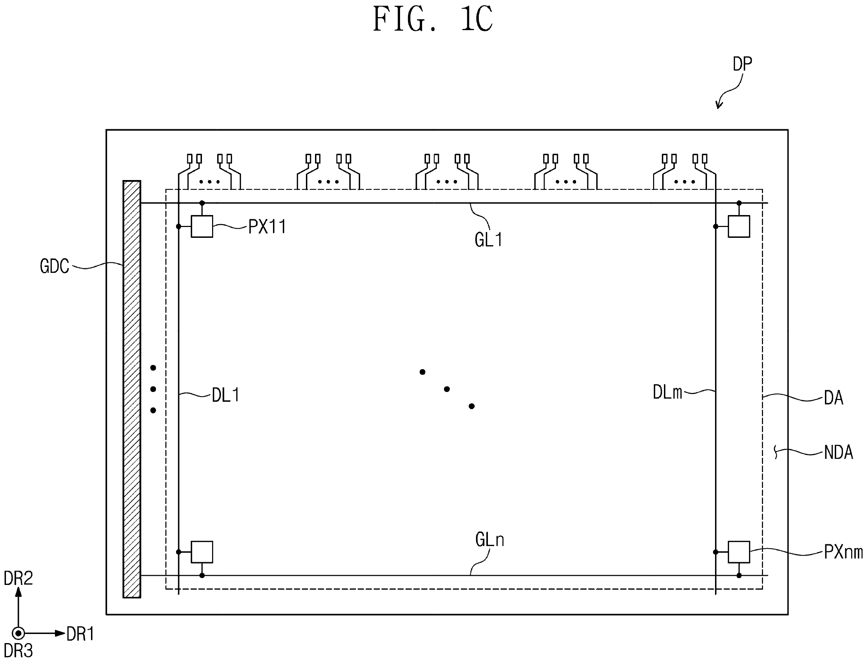

FIG. 1A is a schematic perspective view of a display panel according to an embodiment of the invention. FIG. 1B is a schematic cross-sectional view of the display panel according to an embodiment of the invention. FIG. 1C is a schematic plan view of the display panel according to an embodiment of the invention.

As illustrated in FIG. 1A, the display panel DP may display an image through a display surface DP-IS. The display surface DP-IS may be parallel to a plane defined by a first direction DR1 and a second direction DR2. The display surface DP-IS may include a display region DA and a non-display region NDA. A pixel PX may be disposed in the display region DA, and the pixel PX may not be disposed in the non-display region NDA. The non-display region NDA may be defined along the edge of the display surface DP-IS. The non-display region NDA may surround the display region DA. Without being limited thereto, however, in an embodiment of the invention, the non-display region NDA may be omitted or may be disposed only on one side of the display region DA.

The normal direction of the display surface DP-IS, e.g., the thickness direction of the display panel DP, is indicated by a third direction DR3. The front (or upper) and rear (or lower) surfaces of each layer or part described below are divided by the third direction DR3. However, the first to third directions DR1, DR2, and DR3 illustrated in this embodiment are merely examples.

In an embodiment of the invention, although the display panel DP having a flat display surface DP-IS is illustrated, the embodiment of the invention is not limited thereto. The display panel DP may include a curved display surface or a three-dimensional display surface. The three-dimensional display surface may include display regions indicating different directions.

As illustrated in FIG. 1B, the display panel DP may include a base substrate BS, a circuit element layer DP-CL, a display element layer DP-LED, and/or an optical structure layer OSL. The base substrate BS may include a synthetic resin substrate or a glass substrate. The circuit element layer DP-CL may include at least one insulating layer and a circuit element. The circuit element may include a signal line, a pixel driving circuit, etc. The circuit element layer DP-CL may be formed through a process of forming an insulating layer, a semiconductor layer, and a conductive layer by coating, deposition, etc., and through a process of patterning the insulating layer, the semiconductor layer, and the conductive layer by a photolithography process. The display element layer DP-LED may include at least a display element. The optical structure layer OSL may convert the color of light provided from the display element. The optical structure layer OSL may include a light control pattern and a structure configured to increase light conversion efficiency.

FIG. 1C illustrates the planar arrangement relationship of signal lines GL1 to GLn and DL1 to DLm and pixels PX11 to PXnm. The signal lines GL1 to GLn and DL1 to DLm may include gate lines GL1 to GLn and data lines DL1 to DLm.

Each of the pixels PX11 to PXnm may be connected to a corresponding gate line among the gate lines GL1 to GLn and a corresponding data line among the data lines DL1 to DLm. Each of the pixels PX11 to PXnm may include a pixel driving circuit and a display element. Depending on the configuration of the pixel driving circuits of the pixels PX11 to PXnm, more types of signal lines may be provided on the display panel DP.

A gate driver circuit GDC may be integrated into the display panel DP through an oxide silicon gate driver circuit (OSG) process or an amorphous silicon gate driver circuit (ASG) process.

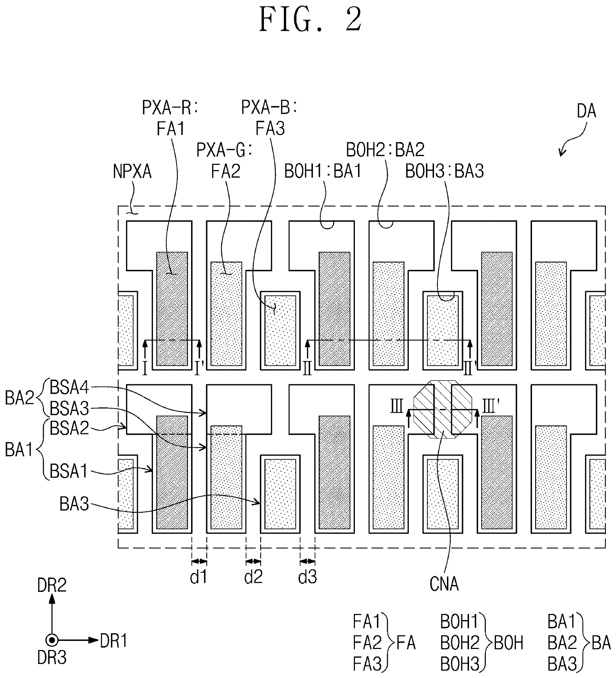

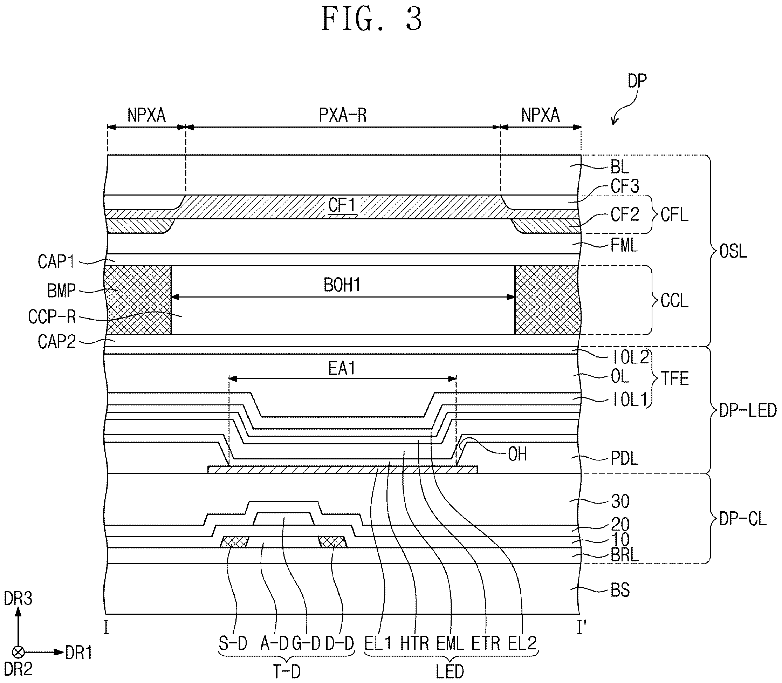

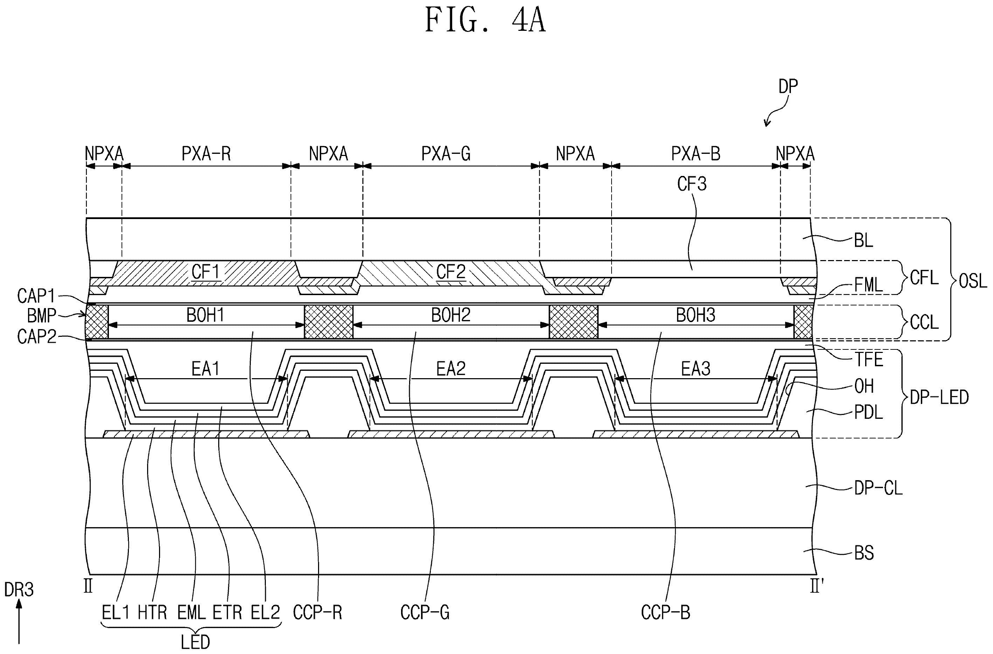

FIG. 2 is a schematic enlarged plan view of a portion of the display panel according to an embodiment of the invention. FIG. 3 is a schematic cross-sectional view of a portion of the display panel according to an embodiment of the invention. FIGS. 4A to 4D are schematic cross-sectional views of a portion of the display panel according to an embodiment of the invention. FIG. 3 illustrates a cross section corresponding to line I-I' illustrated in FIG. 2. FIGS. 4A to 4D illustrate cross sections corresponding to line II-II' illustrated in FIG. 2.

FIG. 2 illustrates the arrangement relationship of pixel regions disposed in the display region DA of the display panel DP (see FIG. 1A) according to an embodiment of the invention. In an embodiment of the invention, the shapes of pixel regions PXA-R, PXA-G, and PXA-B illustrated in FIG. 2 may be repeatedly disposed throughout the display region DA (see FIG. 1A).

Referring to FIG. 2, a peripheral region NPXA may be disposed around the first to third pixel regions PXA-R, PXA-G, and PXA-B. The peripheral region NPXA may set the boundaries of the first to third pixel regions PXA-R, PXA-G, and PXA-B. The peripheral region NPXA may surround the first to third pixel regions PXA-R, PXA-G, and PXA-B.

The first to third pixel regions PXA-R, PXA-G, and PXA-B may correspond to first to third filter regions FA1, FA2, and FA3. Each of the first to third filter regions FA1, FA2, and FA3 may be a region defined by color filters that will be described below.

A structure, such as a pixel defining film PDL (see FIG. 3) or a bank BMP (see FIG. 3), which prevents color mixing between the first to third pixel regions PXA-R, PXA-G, and PXA-B, may be disposed in the peripheral region NPXA. Two or more of color filters to be described below may be disposed to overlap each other in the peripheral region NPXA.

As illustrated in FIG. 2, each of the first to third pixel regions PXA-R, PXA-G, and PXA-B may have a rectangular shape. Each of the first to third pixel regions PXA-R, PXA-G, and PXA-B may have a rectangular shape having a short side extending in the first direction DR1 and a long side extending in the second direction DR2. The areas of the first to third pixel regions PXA-R, PXA-G, and PXA-B may be set according to the color of emitted light. Among primary colors, the area of the pixel region that emits red light may be the largest, and the area of the pixel region that emits blue light may be the smallest. For example, the area of the first pixel region PXA-R that emits red light may be the largest, and the area of the third pixel region PXA-B that emits blue light may be the smallest. However, the invention are not limited thereto, and the areas of the pixel regions may be modified within the scope of spirit of the invention.

FIG. 2 illustrates the first to third pixel regions PXA-R, PXA-G, and PXA-B which have a rectangular shape, but the embodiment of the invention is not limited thereto. On a plane, some of the first to third pixel regions PXA-R, PXA-G, and PXA-B may have different polygonal shapes (including substantially polygonal shapes). In an embodiment of the invention, the first to third pixel regions PXA-R, PXA-G, and PXA-B may have a rectangular shape (substantially rectangular shape) with rounded corners on a plane.

One of the first to third pixel regions PXA-R, PXA-G, and PXA-B may provide red light, another thereof may provide blue light, and the remaining one thereof may provide green light. In this embodiment, the first pixel region PXA-R may provide red light, the second pixel region PXA-G may provide green light, and the third pixel region PXA-B may provide blue light. The first pixel region PXA-R may emit light of a light-emitting wavelength in a range of about 620 nm to about 700 nm, the second pixel region PXA-G may emit light of a light-emitting wavelength in a range of about 520 nm to about 600 nm, and the third pixel region PXA-B may emit light of a light-emitting wavelength in a range of about 410 nm to about 480 nm.

Although not illustrated, a bank well region may be defined in the display region DA. The bank well region may be a region in which a bank well is formed to prevent defects due to misplacement in the process of printing some of light control patterns CCP-R, CCP-G, and CCP-B (see FIG. 4A) included in a light control layer CCL (see FIG. 4A). For example, the bank well region may be a region in which a bank well formed by removing a portion of a bank BMP (see FIG. 4A) is defined.

Referring to FIG. 3, the display panel DP according to an embodiment of the invention may include a base substrate BS, a circuit element layer DP-CL disposed on the base substrate BS, and a display element layer DP-LED disposed on the circuit element layer DP-CL. In this specification, the base substrate BS, the circuit element layer DP-CL, and the display element layer DP-LED may be collectively referred to as a lower panel.

The base substrate BS may be a member that provides a reference surface on which components included in the circuit element layer DP-CL are disposed. In an embodiment of the invention, the base substrate BS may be a glass substrate, a metal substrate, a polymer substrate, or the like. However, the embodiment of the invention is not limited thereto, and the base substrate BS may be an inorganic layer, a functional layer, or a composite material layer.

The base substrate BS may have a multi-layered structure. For example, the base substrate BS may have a three-layer structure of a polymer resin layer, an adhesive layer, and a polymer resin layer. In particular, the polymer resin layer may include a polyimide-based resin. The polymer resin layer may include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In this specification, an "α-based" resin means to include a functional group of "α".

The circuit element layer DP-CL may be disposed on the base substrate BS. The circuit element layer DP-CL may include a transistor T-D as a circuit element. According to the design of the driving circuit of the pixel PX (see FIG. 1A), the configuration of the circuit element layer DP-CL may vary, and FIG. 3 illustrates, as an example, a transistor T-D. The arrangement relationship of an active A-D, a source S-D, a drain D-D, and a gate G-D constituting the transistor T-D is illustrated as an example. The active A-D, the source S-D, and the drain D-D may be divided according to the doping concentration or conductivity of a semiconductor pattern.

The circuit element layer DP-CL may include a lower buffer layer BRL, a first insulating layer 10, a second insulating layer 20, and/or a third insulating layer 30 which are disposed on the base substrate BS. For example, the lower buffer layer BRL, the first insulating layer 10, and the second insulating layer 20 may be inorganic layers, and the third insulating layer 30 may be an organic layer.

The display element layer DP-LED may include a light-emitting element LED as a display element. The light-emitting element LED may generate source light. In an embodiment of the invention, the source light may be white light or blue light. In this embodiment, the display element layer DP-LED may include an organic light-emitting diode as a light-emitting element. For example, a light-emitting layer EML included in the light-emitting element LED may include an organic light-emitting material as a light-emitting material.

The light-emitting element LED may include a first electrode EL1, a second electrode EL2, and a light-emitting layer EML disposed therebetween. In this embodiment, the display element layer DP-LED may include an organic light-emitting diode as a light-emitting element. In an embodiment of the invention, the light-emitting element may include a quantum dot light-emitting diode. For example, the light-emitting layer EML included in the light-emitting element LED may include an organic light-emitting material as a light-emitting material, or the light-emitting layer EML may include a quantum dot as a light-emitting material. As another example, in this embodiment, the display element layer DP-LED may include an ultra-small light-emitting element, which will be described below, as a light-emitting element. The ultra-small light-emitting element may include, for example, a micro LED element and/or a nano LED element. The ultra-small light-emitting element may have a micro- or nano-scale size and include an active layer disposed between semiconductor layers.

A first electrode EL1 may be disposed on the third insulating layer 30. The first electrode EL1 may be connected directly or indirectly to the transistor T-D, and a connection structure between the first electrode EL1 and the transistor T-D is not illustrated in FIG. 3.

The display element layer DP-LED may include a pixel defining film PDL. For example, the pixel defining film PDL may be an organic layer. A light-emitting opening OH may be defined in the pixel defining film PDL. The light-emitting opening OH of the pixel defining film PDL may expose at least a portion of the first electrode EL1. In this embodiment, a first light-emitting region EA1 may be defined by the light-emitting opening OH.

A hole control layer HTR, a light-emitting layer EML, and an electron control layer ETR may overlap at least the first pixel region PXA-R. Each of the hole control layer HTR, the light-emitting layer EML, the electron control layer ETR, and the second electrode EL2 may be commonly disposed in the first to third pixel regions PXA-R, PXA-G, and PXA-B (see FIG. 4A). Each of the hole control layer HTR, the light-emitting layer EML, the electron control layer ETR, and the second electrode EL2 overlapping the first to third pixel regions PXA-R, PXA-G, and PXA-B (see FIG. 4A) may have an integral shape. Without being limited thereto, however, at least one of the hole control layer HTR, the light-emitting layer EML, and the electron control layer ETR may be separately formed in each of the first to third pixel regions PXA-R, PXA-G, and PXA-B (see FIG. 4A). In an embodiment of the invention, the light-emitting layer EML may be patterned in the light-emitting opening OH and separately formed in each of the first to third pixel regions PXA-R, PXA-G, and PXA-B (see FIG. 4A).

The hole control layer HTR may include a hole transport layer and further include a hole injection layer.

The light-emitting layer EML may generate third light which is source light. The light-emitting layer EML may generate blue light. Blue light may include light having a wavelength in a range of about 410 nm to about 480 nm. The light-emitting spectrum of blue light may have a maximum peak in a wavelength range of about 440 nm to about 460 nm.

The electron control layer ETR may include an electron transport layer and further include an electron injection layer.

The display element layer DP-LED may include a thin-film encapsulation layer TFE that protects the second electrode EL2. The thin-film encapsulation layer TFE may include an organic material or an inorganic material. The thin-film encapsulation layer TFE may have a multi-layered structure in which an inorganic layer and an organic layer are repeated. In this embodiment, the thin-film encapsulation layer TFE may include a first inorganic encapsulation layer IOL1/an organic encapsulation layer OL/a second inorganic encapsulation layer IOL2. The first and second inorganic encapsulation layers IOL1 and IOL2 may protect the light-emitting element LED from external moisture, and the organic encapsulation layer OL may prevent the light-emitting element LED from defects caused by being stabbed by foreign substances introduced during a manufacturing process. Although not illustrated, the display panel DP may further include a refractive index control layer on the upper side of the thin-film encapsulation layer TFE to improve light extraction efficiency.

As illustrated in FIG. 3, the optical structure layer OSL may be disposed on the thin-film encapsulation layer TFE. The optical structure layer OSL may include a light control layer CCL, a color filter layer CFL, and/or a base layer BL. In this specification, the optical structure layer OSL may be referred to as an upper panel.

The light control layer CCL may be disposed on the display element layer DP-LED including the light-emitting element LED. The light control layer CCL may include a bank BMP, a first light control pattern CCP-R, and/or a first barrier layer CAP1.

The bank BMP may include a base resin and an additive. The base resin may be composed of various resin compositions which may be generally referred to as a binder. The additive may include a coupling agent and/or a photoinitiator. The additive may further include a dispersant.

The bank BMP may include a black coloring agent to block light. The bank BMP may include a black dye and a black pigment mixed in the base resin. In an embodiment of the invention, the black coloring agent may include carbon black, or may include a metal such as chromium or an oxide thereof.

The bank BMP may include a first bank opening BOH1 corresponding to the light-emitting opening OH. On a plane, the first bank opening BOH1 may overlap the light-emitting opening OH and have a larger area than the light-emitting opening OH. For example, the first bank opening BOH1 may have a larger area than the first light-emitting region EA1 defined by the light-emitting opening OH. In this specification, the expression "one element corresponds to another element" means that two elements overlap each other when viewed in the third direction DR3 of the display panel DP and is not limited to having a same area.

The first light control pattern CCP-R may be disposed inside the first bank opening BOH1. The first light control pattern CCP-R may change the optical properties of source light.

The first light control pattern CCP-R may include a quantum dot to change the optical properties of source light. The first light control pattern CCP-R may include a first quantum dot that converts source light into light of a different wavelength. In the first light control pattern CCP-R overlapping the first pixel region PXA-R, the first quantum dot may convert source light into red light.

In this specification, a "quantum dot" refers to a crystal of a semiconductor compound. The quantum dot may emit light of various light-emitting wavelengths depending on the size of the crystal. The quantum dot may emit light of various light-emitting wavelengths by adjusting the element ratio in a quantum dot compound.

The diameter of the quantum dot may be, for example, in a range of about 1 nm to about 10 nm.

The quantum dot may be synthesized by, for example, a wet chemical process, a metal organic chemical vapor deposition process, a molecular beam epitaxy process, or a process similar thereto.

The wet chemical process may be a method of mixing an organic solvent and a precursor material to each other and growing a quantum dot particle crystal. When the crystal grows, the organic solvent may naturally act as a dispersant coordinated on the surface of the quantum dot crystal and control the growth of the crystal. Therefore, the wet chemical process may be easier than a vapor deposition method such as a metal organic chemical vapor deposition (MOCVD) process or a molecular beam epitaxy (MBE) process, and it is possible to control the growth of quantum dot particles through a low-cost process.

The core of the quantum dot may be selected from a group II-VI compound, a group III-V compound, a group III-VI compound, a group I-III-VI compound, a group II-IV-V compound, a group IV-VI compound, a group IV element, a group IV compound, and combinations thereof.

The group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and mixtures thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and mixtures thereof. The group II-VI semiconductor compound may further include a group I metal and/or a group IV element. A group I-II-VI compound may be selected from CuSnS or CuZnS, and a group II-IV-VI compound may be selected from ZnSnS or the like. A group I-II-IV-VI compound may be selected from quaternary compounds selected from the group consisting of Cu₂ZnSnS₂, Cu₂ZnSnS₄, Cu₂ZnSnSe₄, Ag₂ZnSnS₂, and mixtures thereof.

The group III-VI compound may include a binary compound such as In₂S₃ and In₂Se₃, a ternary compound such as InGaSs and InGaSe₃, or any combinations thereof.

The group I-III-VI compound may be selected from a ternary compound selected from the group consisting of AgInS, AgInS₂, CuInS, CuInS₂, AgGaS₂, CuGaS₂ CuGaO₂, AgGaO₂, AgAlO₂, and mixtures thereof, or a quaternary compound such as AgInGaS₂, and CuInGaS₂.

The group III-V compound may be selected from the group consisting of: a binary compound selected from the group consisting of GaN, GaP, GaAs, GaSb, AlN, AlP, AlAs, AlSb, InN, InP, InAs, InSb, and mixtures thereof; a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and mixtures thereof; and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof. The group III-V compound may further include a group II metal. For example, InZnP and the like may be selected as a group III-II-V compound.

The group IV-VI compound may be selected from the group consisting of: a binary compound selected from the group consisting of SnS, SnSe, SnTe, PbS, PbSe, PbTe, and mixtures thereof; a ternary compound selected from the group consisting of SnSeS, SnSeTe, SnSTe, PbSeS, PbSeTe, PbSTe, SnPbS, SnPbSe, SnPbTe, and mixtures thereof; and a quaternary compound selected from the group consisting of SnPbSSe, SnPbSeTe, SnPbSTe, and mixtures thereof.

The group II-IV-V compound may be a ternary compound selected from the group consisting of ZnSnP, ZnSnP₂, ZnSnAs₂, ZnGeP₂, ZnGeAs₂, CdSnP₂, CdGeP₂, and mixtures thereof.

The group IV element may be selected from the group consisting of Si, Ge, and mixtures thereof. The group IV compound may be a binary compound selected from the group consisting of SiC, SiGe, and a mixture thereof.

Each element included in multi-element compounds, such as the binary compounds, the ternary compounds, and the quaternary compounds, may be present in a particle at a uniform or non-uniform concentration. For example, the above chemical formulas may mean types of elements included in the compounds, and the ratios of elements in the compounds may be different from each other. For example, AgInGaS₂ may mean AgInₓGa₁₋ₓS₂ (x is a real number between 0 and 1).

In this case, the binary compounds, the ternary compounds, or the quaternary compounds may be present in a particle at a uniform concentration, or they may be present in a same particle after being divided into states in which the concentration distributions thereof are partially different from one another. The quantum dots may have a core/shell structure in which one quantum dot surrounds another quantum dot. The core/shell structure may have a concentration gradient in which the concentration of an element present in the shell gradually decreases toward the core.

In some embodiments of the invention, the quantum dots may have a core-shell structure including a core including a nanocrystal described above and a shell surrounding the core. The shell of the quantum dots may serve as a protective layer for maintaining semiconductor characteristics by preventing the chemical modification of the core and/or as a charging layer for imparting electrophoretic characteristics to the quantum dots. The shell may be single-layered or multi-layered. An example of the shell of the quantum dots may include a metal or non-metal oxide, a semiconductor compound, or a combination thereof.

For example, the metal or non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO, or a ternary compound such as MgAl₂O₄, CoFe₂O₄, NiFe₂O₄, and CoMn₂O₄, but the embodiment of the invention is not limited thereto.

In addition, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and the like, but the embodiment of the invention is not limited thereto.

The quantum dot may have a full width of half maximum (FWHM) of a light-emitting wavelength spectrum of about 45 nm or less, for example, about 40 nm or less, or, as another example, about 30 nm or less, and within those ranges, it is possible to improve color purity or color reproducibility. Since light emitted through the quantum dot is emitted in all directions, a wide viewing angle may be improved.

The shape of the quantum dot is not particularly limited to those generally used in the art, but more specifically, a shape such as a spherical, pyramidal, or multi-armed shape, or a shape of a cubic nanoparticle, nanotube, nanowire, nanofiber, and nanoplate particle may be used.

Since an energy band gap may be controlled by adjusting the size of the quantum dot or the ratio of elements in a quantum dot compound, light of various wavelengths may be obtained from a quantum dot light-emitting layer. Therefore, by using the quantum dot described above (using quantum dots of different sizes or different element ratios in the quantum dot compound), a light-emitting element configured to emit light of various wavelengths may be implemented. Specifically, the control of the size of the quantum dot or the ratio of elements in the quantum dot compound may be selected so as to emit red light, green light, and/or blue light. The quantum dots may be configured to emit white light by combining light of various colors.

In an embodiment of the invention, the quantum dot included in the first light control pattern CCP-R overlapping the first pixel region PXA-R may have a red light-emitting color. In case that the particle size of a quantum dot is smaller, light of a shorter wavelength range may be emitted. For example, among quantum dots having a same core, the quantum dots emitting green light may have a smaller particle size than the quantum dots emitting red light. Among quantum dots having a same core, the quantum dots emitting blue light may have a smaller particle size than the quantum dots emitting green light. However, the embodiment of the invention is not limited thereto, and even among quantum dots having a same core, the particle size thereof may be adjusted according to a shell-forming material, a shell thickness, and the like.

In case that the quantum dots have various light-emitting colors such as a blue color, a red color, and a green color, the quantum dots having different light-emitting colors may respectively have different core materials.

The first light control pattern CCP-R may further include a scatterer. The first light control pattern CCP-R may include a first quantum dot, which converts blue light into red light, and a scatterer which scatters light.

The scatterer may be an inorganic particle. For example, the scatterer may include at least one of TiO₂, ZnO, Al₂O₃, SiO₂, and hollow silica. The scatterer may include at least one of TiO₂, ZnO, Al₂O₃, SiO₂, and hollow silica, or may be a mixture of two or more materials selected from TiO₂, ZnO, Al₂O₃, SiO₂, and hollow silica.

The first light control pattern CCP-R may include a base resin that disperses first quantum dots and scatterers. The base resin may be a medium, in which the first quantum dots and the scatterers are dispersed, and may be made of various resin compositions which may generally be referred to as a binder. For example, the base resin may be an acrylic-based resin, a urethane-based resin, a silicone-based resin, an epoxy-based resin, or the like. The base resin may be a transparent resin.

In this embodiment, the first light control pattern CCP-R may be formed by an inkjet process. A liquid composition may be provided in the bank opening BOH. The volume of the composition which is polymerized through a heat curing process or a light curing process may be reduced after curing.

The light control layer CCL may include a first barrier layer CAP1 disposed on one surface of the first light control pattern CCP-R. The first barrier layer CAP1 may serve to prevent the penetration of moisture and/or oxygen (hereinafter referred to as 'moisture/oxygen') and improve the optical properties of the optical structure layer OSL by adjusting a refractive index. The first barrier layer CAP1 may be disposed on the upper or lower surface of the first light control pattern CCP-R to be able to block the first light control pattern CCP-R from being exposed to moisture/oxygen, and in particular, the quantum dots included in the first light control pattern CCP-R may be blocked from being exposed to moisture/oxygen. The first barrier layer CAP1 may also protect the first light control pattern CCP-R from an external impact.

In an embodiment of the invention, the first barrier layer CAP1 may be disposed to be spaced apart from the display element layer DP-LED with the first light control pattern CCP-R interposed therebetween. For example, the first barrier layer CAP1 may be disposed on the upper surface of the first light control pattern CCP-R. In an embodiment of the invention, the light control layer CCL may include a second barrier layer CAP2 disposed between the first light control pattern CCP-R and the display element layer DP-LED. The first barrier layer CAP1 may cover the upper surface of the first light control pattern CCP-R adjacent to the color filter layer CFL, and the second barrier layer CAP2 may cover the lower surface of the first light control pattern CCP-R adjacent to the display element layer DP-LED. In this specification, the "upper surface" may be a surface located at the top, based on the third direction DR3, and the "lower surface" may be a surface located at the bottom, based on the third direction DR3.

The first barrier layer CAP1 and the second barrier layer CAP2 may cover a surface of the bank BMP as well as the first light control pattern CCP-R.

The first barrier layer CAP1 may cover a surface of the bank BMP and the first light control pattern CCP-R adjacent to the color filter layer CFL. The first barrier layer CAP1 may be disposed directly below the filling layer FML. The second barrier layer CAP2 may be disposed directly on the thin-film encapsulation layer TFE. The light control layer CCL may be disposed on the display element layer DP-LED and the thin-film encapsulation layer TFE with the second barrier layer CAP2 interposed therebetween. The light control patterns CCP-R, CCP-G, and CCP-B of the light control layer CCL may be formed in a continuous process on the second barrier layer CAP2 disposed on the thin-film encapsulation layer TFE.

The first barrier layer CAP1 and the second barrier layer CAP2 may include an inorganic material. In the display panel DP according to an embodiment of the invention, the first barrier layer CAP1 may include silicon oxynitride (SiON). The first barrier layer CAP1 and the second barrier layer CAP2 may include silicon oxynitride. For example, without being limited thereto, however, each of the first barrier layer CAP1 and the second barrier layer CAP2 may include silicon oxide (SiOₓ) or silicon nitride (SiNₓ). In an embodiment of the invention, the first barrier layer CAP1 disposed on the first light control pattern CCP-R may include silicon oxynitride, and the second barrier layer CAP2 disposed below the first light control pattern CCP-R may include silicon oxide.

A color filter layer CFL may be disposed on the light control layer CCL. The color filter layer CFL may include at least one color filter. The color filter may transmit light of a specific wavelength range and block light outside the wavelength range. A first color filter CF1 corresponding to the first pixel region PXA-R may transmit red light and block green light and blue light.

The first color filter CF1 may include a base resin and dye and/or pigment dispersed in the base resin. The base resin may be a medium, in which dye and/or pigment are dispersed, and may be made of various resin compositions which may be generally referred to as a binder.

The first color filter CF1 may have a uniform thickness in the first pixel region PXA-R. Light converted from blue light, which is source light, to red light through the first light control pattern CCP-R may be provided to the outside with uniform luminance in the first pixel region PXA-R.

The optical structure layer OSL may further include a filling layer FML disposed between the light control layer CCL and the color filter layer CFL. In an embodiment of the invention, the filling layer FML may fill a space between the light control layer CCL and the color filter layer CFL. The filling layer FML may be disposed directly on the first barrier layer CAP1, and the color filter layer CFL may be disposed directly on the filling layer FML. The lower surface of the filling layer FML may contact the upper surface of the first barrier layer CAP1, and the upper surface of the filling layer FML may contact the lower surfaces of color filters CF1, CF2, and CF3 of the color filter layer CFL.

The filling layer FML may function as a buffer between the light control layer CCL and the color filter layer CFL. In an embodiment of the invention, the filling layer FML may function as a shock absorber or the like and increase the strength of the display panel DP. The filling layer FML may be formed from a filling resin including a polymer resin. For example, the filling layer FML may be formed from a filling resin including an acrylic-based resin, an epoxy-based resin, or the like.

By being disposed between the light control layer CCL and the color filter layer CFL, the filling layer FML may function as an optical functional layer to increase light extraction efficiency or prevent reflected light from entering the light control layer CCL. The filling layer FML may have a lower refractive index than an adjacent layer.

In an embodiment of the invention, the display panel DP may further include a base layer BL disposed on the color filter layer CFL. The base layer BL may be a member that provides a reference surface on which the color filter layer CFL, and the light control layer CCL are disposed. The base layer BL may be a glass substrate, a metal substrate, or a plastic substrate. However, the embodiment of the invention is not limited thereto, and the base layer BL may be an inorganic layer, an organic layer, or a composite material layer. Unlike what is illustrated, in an embodiment of the invention, the base layer BL may be omitted.

Although not illustrated, an anti-reflection layer may be disposed on the base layer BL. The anti-reflection layer may reduce the reflectance of external light incident from the outside. The anti-reflection layer may selectively transmit light emitted from the display panel DP. In an embodiment of the invention, the anti-reflection layer may be a single layer including dye and/or pigment dispersed in the base resin. The anti-reflection layer may be provided as one continuous layer that completely overlaps the entire first to third pixel regions PXA-R, PXA-G, and PXA-B (see FIG. 4A).

The anti-reflection layer may not include a polarizing layer. Accordingly, light directed toward the display element layer DP-LED through the anti-reflection layer may not be polarized. The display element layer DP-LED may receive unpolarized light from above the anti-reflection layer.

Referring to FIG. 4A, the display panel DP may include a base substrate BS and a circuit element layer DP-CL disposed on the base substrate BS. The circuit element layer DP-CL may be disposed on the base substrate BS. The circuit element layer DP-CL may include an insulating layer, a semiconductor pattern, a conductive pattern, and a signal line. An insulating layer, a semiconductor layer, and a conductive layer may be formed on the base substrate BS by coating, deposition, or the like, and the insulating layer, the semiconductor layer, and the conductive layer may be selectively patterned through photolithography processes. Hereafter, a semiconductor pattern, a conductive pattern, and a signal line included in the circuit element layer DP-CL may be formed. In an embodiment of the invention, the circuit element layer DP-CL may include a transistor, a buffer layer, and insulating layers.

The light-emitting element LED according to an embodiment of the invention may include a first electrode EL1, a second electrode EL2 configured to face the first electrode EL1, and a light-emitting layer EML disposed between the first electrode EL1 and the second electrode EL2. The light-emitting layer EML included in the light-emitting element LED may include an organic light-emitting material or a quantum dot as a light-emitting material. The light-emitting element LED may further include a hole control layer HTR and an electron control layer ETR. Although not illustrated, the light-emitting element LED may further include a capping layer (not illustrated) disposed on the second electrode EL2.

The pixel defining film PDL may be disposed on the circuit element layer DP-CL and cover a portion of the first electrode EL1. A light-emitting opening OH may be defined in the pixel defining film PDL. The light-emitting opening OH of the pixel defining film PDL may expose at least a portion of the first electrode EL1. In this embodiment, light-emitting regions EA1, EA2, and EA3 may be defined to correspond to a region of the first electrode EL1 exposed by the light-emitting opening OH.

The display element layer DP-LED may include a first light-emitting region EA1, a second light-emitting region EA2, and a third light-emitting region EA3. The first light-emitting region EA1, the second light-emitting region EA2, and the third light-emitting region EA3 may be divided by the pixel defining film PDL. The first light-emitting region EA1, the second light-emitting region EA2, and the third light-emitting region EA3 may respectively correspond to the first pixel region PXA-R, the second pixel region PXA-G, and the third pixel region PXA-B.

The light-emitting regions EA1, EA2, and EA3 may overlap the pixel regions PXA-R, PXA-G, and PXA-B. When viewed on a plane, the areas of the pixel regions PXA-R, PXA-G, and PXA-B divided by the color filters CF1, CF2, and CF3 may be at least substantially equal (or equal) to the areas of the light-emitting regions EA1, EA2, and EA3.

In the light-emitting element LED, the first electrode EL1 may be disposed on the circuit element layer DP-CL. The first electrode EL1 may be an anode or a cathode. The first electrode EL1 may be a pixel electrode. The first electrode EL1 may be a transmissive electrode, a semi-transmissive electrode, or a reflective electrode.

The hole control layer HTR may be disposed between the first electrode EL1 and the light-emitting layer EML. The hole control layer HTR may include at least one of a hole injection layer, a hole transport layer, and an electron blocking layer. The hole control layer HTR may be disposed as a common layer so as to overlap the light-emitting regions EA1, EA2, and EA3 and the entire pixel defining film PDL that separates the light-emitting regions EA1, EA2, and EA3 from each other. However, the embodiment of the invention is not limited thereto, and the hole control layer HTR may be patterned and provided so as to be separately disposed to correspond to each of the light-emitting regions EA1, EA2, and EA3.

The light-emitting layer EML may be disposed on the hole control layer HTR. In an embodiment of the invention, the light-emitting layer EML may be provided as a common layer so as to overlap the light-emitting regions EA1, EA2, and EA3 and the entire pixel defining film PDL that separates the light-emitting regions EA1, EA2, and EA3 from each other. In an embodiment of the invention, the light-emitting layer EML may emit blue light. The light-emitting layer EML may entirely overlap the hole control layer HTR and the electron control layer ETR

However, the embodiment of the invention is not limited thereto, and in an embodiment of the invention, the light-emitting layer EML may be disposed in the light-emitting opening OH. For example, the light-emitting layer EML may be separately formed so as to correspond to the light-emitting regions EA1, EA2, and EA3 divided by the pixel defining film PDL. The light-emitting layers EML separately formed so as to correspond to the light-emitting regions EA1, EA2, and EA3 may all emit blue light or may emit light of different wavelength ranges.

The light-emitting layer EML may have a single-layered structure composed of a single material, a single-layered structure composed of different materials, or a multi-layered structure having layers composed of different materials. The light-emitting layer EML may include a fluorescent or phosphorescent material. In the light-emitting element LED according to an embodiment of the invention, the light-emitting layer EML may include a light-emitting material such as an organic light-emitting material, a metal organic complex, or a quantum dot. FIGS. 3 and 4A illustrate, as an example, the light-emitting element LED including one light-emitting layer EML, but in an embodiment of the invention, the light-emitting element LED may include light-emitting stacks each including at least one light-emitting layer.

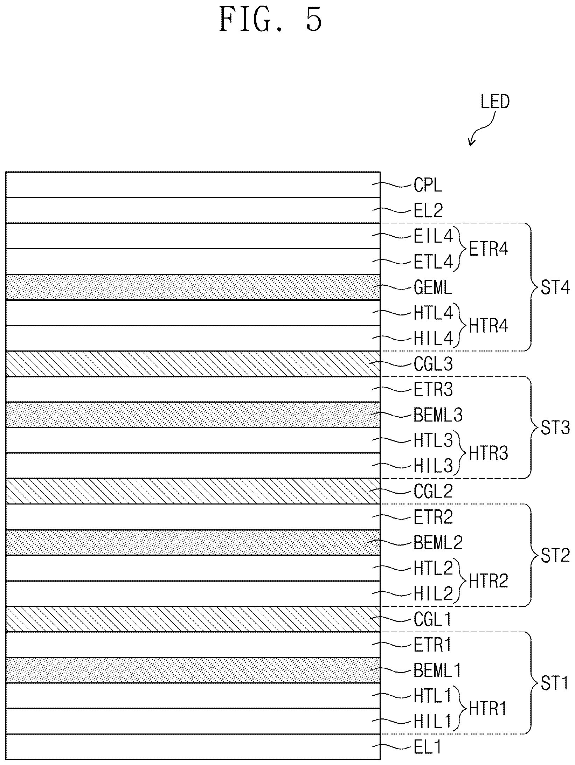

FIG. 5 is a schematic cross-sectional view of a light-emitting element according to an embodiment of the invention. Unlike the light-emitting element according to an embodiment of the invention, which is illustrated in FIGS. 3 and 4A, FIG. 5 illustrates, as an example, a light-emitting element LED including light-emitting stacks ST1, ST2, ST3, and ST4.

Referring to FIG. 5, the light-emitting element LED according to an embodiment of the invention may include a first electrode EL1, a second electrode EL2 configured to face the first electrode EL1, and first to fourth light-emitting stacks ST1, ST2, ST3, and ST4 disposed between the first electrode EL1 and the second electrode EL2. FIG. 5 illustrates, as an example, that the light-emitting element LED includes four light-emitting stacks, but the number of the light-emitting stacks included in the light-emitting element LED may be less or more than this.

The light-emitting element LED may include first to third charge generation layers CGL1, CGL2, and CGL3 disposed between the first to fourth light-emitting stacks ST1, ST2, ST3, and ST4.

In case that a voltage is applied, each of the first to third charge generation layers CGL1, CGL2, and CGL3 may generate charges (electrons and holes) by forming a complex through an oxidation-reduction reaction. Hereafter, the first to third charge generation layers CGL1, CGL2, and CGL3 may provide the generated charges to the light-emitting stacks ST1, ST2, ST3, and ST4 adjacent thereto. The first to third charge generation layers CGL1, CGL2, and CGL3 may double the efficiency of a current generated in the light-emitting stacks ST1, ST2, ST3, and ST4 adjacent thereto and may play a role in controlling the balance of charges between the light-emitting stacks ST1, ST2, ST3, and ST4 adjacent thereto.

Each of the first to third charge generation layers CGL1, CGL2, and CGL3 may include an n-type layer and a p-type layer. The first to third charge generation layers CGL1, CGL2, and CGL3 may have a structure in which the n-type layer and the p-type layer are bonded to each other. Without being limited thereto, however, the first to third charge generation layers CGL1, CGL2, and CGL3 may include only at least one of the n-type layer and the p-type layer. The n-type layer may be a charge generation layer that provides electrons to an adjacent light-emitting stack. The n-type layer may be a layer in which an n-dopant is doped in a base material. The p-type layer may be a charge generation layer that provides holes to an adjacent light-emitting stack.

In an embodiment of the invention, the thickness of each of the first to third charge generation layers CGL1, CGL2, and CGL3 may be in a range of about 1 Angstrom (Å) to about 150 Angstroms (Å). The concentration of the n-dopant doped in the first to third charge generation layers CGL1, CGL2, and CGL3 may be in a range of about 0.1% to about 3%, for example, about 0.1% to about 1%. In case that the concentration is less than about 0.1%, the effect of the first to third charge generation layers CGL1, CGL2, and CGL3 which control the balance of charges may hardly occur. In case that the concentration is greater than about 3%, the light efficiency of the light-emitting element LED may be reduced.

Each of the first to third charge generation layers CGL1, CGL2, and CGL3 may include a charge generation compound composed of an arylamine-based organic compound, a metal, a metal oxide, a metal carbide, a metal fluoride, or a mixture thereof. For example, the arylamine-based organic compound may include α-NPD, 2-TNATA, TDATA, MTDATA, spiro-TAD, or spiro-NPB. The metal may include cesium (Cs), molybdenum (Mo), vanadium (V), titanium (Ti), tungsten (W), barium (Ba), or lithium (Li). The metal oxide, the metal carbide, and the metal fluoride may include Re₂O₇, MoOs, V₂O₅, WO₃, TiO₂, Cs₂CO₃, BaF, LiF, or CsF. However, the materials of the first to third charge generation layers CGL1, CGL2, and CGL3 are not limited to the above examples.

Each of the first to fourth light-emitting stacks ST1, ST2, ST3, and ST4 may include a light-emitting layer. The first light-emitting stack ST1 may include a first light-emitting layer BEMI,1, the second light-emitting stack ST2 may include a second light-emitting layer BEML2, the third light-emitting stack ST3 may include a third light-emitting layer BEML3, and the fourth light-emitting stack ST4 may include a fourth light-emitting layer GEML. Some of the light-emitting layers included in the first to fourth light-emitting stacks ST1, ST2, ST3, and ST4 may emit light of at least substantially a same color, and some of them may emit light of different colors.

In an embodiment of the invention, the first to third light-emitting layers BEML1, BEMI,2, and BEML3 of the first to third light-emitting stacks ST1, ST2, and ST3 may emit at least substantially a same first color light. For example, the first color light may be blue light which is the source light described above. The wavelength range of light emitted from the first to third light-emitting layers BEMI,1, BEMI,2, and BEML3 may be about 420 nm to about 480 nm.

The fourth light-emitting layer GEMI, of the fourth light-emitting stack ST4 may emit a second color light different from the first color light. For example, the second color light may be green light. The wavelength range of light emitted from the fourth light-emitting layer GEMI, may be about 520 nm to about 600 nm.

The light-emitting element LED may emit light in the direction from the first electrode EL1 to the second electrode EL2. In the light-emitting element LED according to an embodiment of the invention, the light-emitting stacks ST1, ST2, ST3, and ST4 may respectively include hole transport regions HTR1, HTR2, HTR3, and HTR4 and electron transport regions ETR1, ETR2, ETR3, and ETR4. The hole transport regions HTR1, HTR2, HTR3, and HTR4 may transmit holes, which are provided from the first electrode EL1 or the charge generation layer CGL1, CGL2, and CGL3, to the light-emitting layer. The electron transport regions ETR1, ETR2, ETR3, and ETR4 may transmit electrons, which are provided from the second electrode EL2 or the charge generation layer CGL1, CGL2, and CGL3, to the light-emitting layer.

It is illustrated as an example that, based on the direction in which light is emitted, the light-emitting element LED according to an embodiment of the invention has a structure in which the hole transport regions HTR1, HTR2, HTR3, and HTR4 are disposed below the light-emitting layers BEMI,1, BEMI,2, BEML3, and GEMI, included in the light-emitting stacks ST1, ST2, ST3, and ST4, and the electron transport regions ETR1, ETR2, ETR3, and ETR4 are disposed on the light-emitting layers BEMI,1, BEMI,2, BEML3, and GEMI, included in the light-emitting stacks ST1, ST2, ST3, and ST4. For example, the light-emitting element LED according to an embodiment of the invention may have a forward element structure. Without being limited thereto, however, based on the direction in which light is emitted, the light-emitting element LED according to an embodiment of the invention may have an inverted element structure in which the electron transport regions ETR1, ETR2, ETR3, and ETR4 are disposed below the light-emitting layers BEMI,1, BEMI,2, BEML3, and GEMI, included in the light-emitting stacks ST1, ST2, ST3, and ST4, and the hole transport regions HTR1, HTR2, HTR3, and HTR4 are disposed on the light-emitting layers BEMI,1, BEMI,2, BEML3, and GEMI, included in the light-emitting stacks ST1, ST2, ST3, and ST4.

The hole transport regions HTR1, HTR2, HTR3, and HTR4 may respectively include hole injection layers HIL1, HIL2, HIL3, and HIL4 and hole transport layers HTL1, HTL2, HTL3, and HTL4 disposed on the hole injection layers HIL1, HIL2, HIL3, and HIL4. The hole transport layers HTL1, HTL2, HTL3, and HTL4 may contact the lower surface of the light-emitting layer. Without being limited thereto, however, the hole transport regions HTR1, HTR2, HTR3, and HTR4 may further include a hole-side additional layer disposed on the hole transport layers HTL1, HTL2, HTL3, and HTL4. The hole-side additional layer may include at least one of a hole buffer layer, a light-emitting auxiliary layer, or an electron blocking layer. The hole buffer layer may increase light-emitting efficiency by compensating for a resonance distance depending on the wavelength of light emitted from the light-emitting layer. The electron blocking layer may serve to prevent electrons from being injected from the electron transport regions to the hole transport regions.

The electron transport regions ETR1, ETR2, ETR3, and ETR4 may include an electron transport layer. The electron transport regions ETR1, ETR2, ETR3, and ETR4 may further include an electron injection layer disposed on the electron transport layer. For example, a fourth electron transport region ETR4 included in the fourth light-emitting stack ST4 may further include a fourth electron injection layer EIL4 disposed on a fourth electron transport layer ETL4. The electron transport regions ETR1, ETR2, ETR3, and ETR4 may further include an electron-side additional layer disposed between the electron transport layer and the light-emitting layer. The electron-side additional layer may include at least one of an electron buffer layer and a hole blocking layer.

In the light-emitting element LED according to an embodiment of the invention, the first electrode EL1 may be a reflective electrode. For example, the first electrode EL1 may include Ag, Mg, Cu, Al, Pt, Pd, Au, Ni, Nd, Ir, Cr, Li, Ca, LiF/Ca, LiF/Al, Mo, Ti, W, In, Zn, Sn, or a compound or mixture thereof (for example, a mixture of Ag and Mg), which exhibits a high reflectance. As another example, the first electrode EL1 may have a multi-layered structure including a reflective film formed of the above materials, and a transparent conductive film formed of indium tin oxide (ITO), indium zinc oxide (IZO), zinc oxide (ZnO), indium tin zinc oxide (ITZO), and the like. For example, the first electrode EL1 may have a two-layer structure of ITO/Ag and a three-layer structure of ITO/Ag/ITO, but the embodiment of the invention is not limited thereto. Without being limited thereto, the first electrode EL1 may include an above-described metal material, a combination of two or more metal materials selected from among the above-described metal materials, an oxide of the above-described metal materials, or the like. The thickness of the first electrode EL1 may be in a range of about 70 nm to about 1000 nm. For example, the thickness of the first electrode EL1 may be in a range of about 100 nm to about 300 nm.

In the light-emitting element LED according to an embodiment of the invention, each of the hole transport regions HTR1, HTR2, HTR3, and HTR4 may have a single-layered structure made of a single material, a single-layered structure made of different materials, or a multi-layered structure having layers made of different materials.

The hole transport regions HTR1, HTR2, HTR3, and HTR4 may be formed by using various methods such as a vacuum deposition method, a spin coating method, a casting method, a Langmuir-Blodgett (LB) method, an inkjet printing method, a laser printing method, and a laser induced thermal imaging (LITI) method.

Each of the hole transport regions HTR1, HTR2, HTR3, and HTR4 may contain a phthalocyanine compound such as copper phthalocyanine, DNTPD(N1,N1'-([1,1'-biphenyl]-4,4'-diyl)bis(N1-phenyl-N4,N4-di-m-tolylbenzene-1,4-diamine)), m-MTDATA(4,4',4"-[tris(3-methylphenyl)phenylamino]triphenylamine), TDATA(4,4',4"-Tris(N,N-diphenylamino)triphenylamine), 2-TNATA(4,4',4"-tris[N(2-naphthyl)-N-phenylamino]-triphenylamine), PEDOT/PSS(Poly(3,4-ethylenedioxythiophene)/Poly(4-styrenesulfonate)), PANI/DBSA(Polyaniline/Dodecylbenzenesulfonic acid), PANI/CSA(Polyaniline/Camphor sulfonicacid), PANI/PSS(Polyaniline/Poly(4-styrenesulfonate)), NPB(N,N'-di(naphthalene-1-yl)-N,N'-diphenyl-benzidine), polyether ketone(TPAPEK) containing triphenylamine, 4-Isopropyl-4'-methyldiphenyliodonium[Tetrakis(pentafluorophenyl)borate], HATCN(dipyrazino [2,3-f: 2', 3'-h] quinoxaline-2,3,6,7,10,11-hexacarbonitrile), etc.

Each of the hole transport regions HTR1, HTR2, HTR3, and HTR4 may contain a carbazole-based derivative such as N-phenylcarbazole and polyvinylcarbazole, a fluorene-based derivative, TPD(N,N'-bis(3-methylphenyl)-N,N'-diphenyl-[1,1'-biphenyl]-4,4'-diamine), a triphenylamine-based derivative such as TCTA(4,4',4"-tris(N-carbazolyl)triphenylamine), NPB(N,N'-di(naphthalene-1-yl)-N,N'-diplienyl-benzidine), TAPC(4,4'-Cyclohexylidene bis[N,N-bis(4-methylphenyl)benzenamine]), HMTPD(4,4'-Bis[N,N'-(3-tolyl)amino]-3,3'-dimethylbiphenyl), mCP(1,3-Bis (N-carbazolyl) benzene), etc.

Each of the hole transport regions HTR1, HTR2, HTR3, and HTR4 may contain CzSi(9-(4-tert-Butylphenyl)-3,6-bis(triphenylsilyl)-9H-carbazole), CCP(9-phenyl-9H-3,9'-bicarbazole), mDCP(1,3-bis(1,8-dimethyl-9H-carbazol-9-yl)benzene), or the like.

In the hole transport region HTR1, HTR2, HTR3, and HTR4, the compounds of the hole transport region described above may be included in at least one of the hole injection layers HIL1, HIL2, HIL3, and HIL4, the hole transport layers HTL1, HTL2, HTL3, and HTL4, and the hole-side additional layer.

The thickness of each of the hole transport regions HTR1, HTR2, HTR3, and HTR4 may be in a range of about 10 nm to about 1000 nm, for example, about 10 nm to about 500 nm. The thickness of each of the hole injection layers HIL1, HIL2, HIL3, and HIL4 may be, for example, in a range of about 5 nm to about 100 nm. The thickness of each of the hole transport layers HTL1, HTL2, HTL3, and HTL4 may be in a range of about 5 nm to about 100 nm. In case that the hole transport regions HTR1, HTR2, HTR3, and HTR4 include a hole-side additional layer, the thickness of the hole-side additional layer may be in a range of about 1 nm to about 100 nm. In case that the thickness of the hole transport regions HTR1, HTR2, HTR3, and HTR4 and the thickness of each layer included in them satisfy the above-mentioned ranges, satisfactory hole transport characteristics may be obtained without a substantial increase in driving voltage.

In addition to the materials mentioned above, each of the hole transport regions HTR1, HTR2, HTR3, and HTR4 may further include a charge generation material to improve conductivity. The charge generation material may be uniformly or non-uniformly dispersed within the hole transport regions HTR1, HTR2, HTR3, and HTR4. The charge generation material may be, for example, a p-type dopant. The p-type dopant may include at least one of a halogenated metal compound, a quinone derivative, a metal oxide, and a cyano group-containing compound, but the embodiment of the invention is not limited thereto. For example, the p-dopant may contain a halogenated metal compound such as CuI and RbI, a quinone derivative such as TCNQ(Tetracyanoquinodimethane) and E4-TCNQ(2,3,5,6-tetrafluoro-7,7'8,8-tetracyanoquinodimethane), a metal oxide such as a tungsten oxide and a molybdenum oxide, and the like, but the embodiment of the invention is not limited thereto.

Each of the blue light-emitting layers BEML1, BEML2, and BEML3 and the green light-emitting layer GEMI, may include a host material and a dopant material. Each of the blue light-emitting layers BEML1, BEML2, and BEML3 and the green light-emitting layer GEMI, may include a material containing a carbazole derivative moiety or an amine derivative moiety as a hole transporting host material. Each of the blue light-emitting layers BEML1, BEML2, and BEML3 and the green light-emitting layer GEMI, may include a material having a nitrogen-containing aromatic ring structure, such as a pyridine derivative moiety, a pyridazine derivative moiety, a pyrimidine derivative moiety, a pyrazine derivative moiety, and a triazine derivative moiety, as an electron transporting host material.

Each of the blue light-emitting layers BEML1, BEML2, and BEML3 and the green light-emitting layer GEMI, may include an anthracene derivative, a pyrene derivative, a fluoranthene derivative, a chrysene derivative, a dihydrobenzo anthracene derivative, or a triphenylene derivative as a host material. Each of the blue light-emitting layers BEML1, BEML2, and BEML3 and the green light-emitting layer GEMI, may further include a general material known in the art as a host material. For example, as a host material, each of the blue light-emitting layers BEML1, BEML2, and BEML3 and the green light-emitting layer GEMI, may include at least one of DPEPO (Bis[2-(diphenylphosphino)phenyl] ether oxide), CBP (4,4'-Bis(carbazol-9-yl)biphenyl), mCP(1,3-Bis(carbazol-9-yl)benzene), PPF(2,8-Bis(diphenylphosphoryl)dibenzo[b,d]furan), TCTA(4,4',4"-Tris(carbazol-9-yl)-triphenylamine), and TPBi(1,3,5-tris(1 -phenyl-1H-benzo[d]imidazole-2-yl)benzene). However, the embodiment of the invention is not limited thereto, and for example, Alq₃ (tris(8-hydroxyquinolino)aluminum), PVK (poly(N-vinylcarbazole), ADN (9,10-di(naphthalene-2-yl)anthracene), TBADN (2-tert-butyl-9,10-di(naphth-2-yl)anthracene), DSA(distyrylarylene), CDBP(4,4'-bis(9-carbazolyl)-2,2'-dimethyl-biphenyl), MADN(2-Methyl-9,10-bis(naphthalen-2-yl)anthracene), CP1(Hexaphenyl cyclotriphosphazene), UGH2(1,4-Bis(triphenylsilyl)benzene), DPSiO₃ (Hexaphenylcyclotrisiloxane), DPSiO₄ (Octaphenylcyclotetra) siloxane), and the like may be used as a host material.

In an embodiment of the invention, as a known fluorescent dopant material, the blue light-emitting layers BEML1, BEML2, and BEML3 may include a styryl derivative (e.g., 1,4-bis[2-(3-N-ethylcarbazoryl)vinyl]benzene (BCzVB), 4-(di-p-tolylamino)-4'-[(di-p-tolylamino)styryl]stilbene(DPAVB), N-(4-((E)-2-(6-((E)-4-(diphenylamino)styryl)naphthalen-2-yl)vinyl)phenyl)-N-phenylbenzenamine(N-BDAVBi)), 4,4'-bis[2-(4-(N,N-diphenylamino)phenyl)vinyl] biphenyl(DPAVBi), perylene and its derivative (e.g., 2,5,8,11-Tetra-t-butylperylene (TBP)), pyrene and its derivative (e.g., 1,1-dipyrene,1,4-dipyrenylbenzene,1,4-Bis(N, N-Diphenylamino)pyrene), and the like.

The green light-emitting layer GEMI, may include a known phosphorescent dopant material. For example, a metal complex containing iridium (Ir), platinum (Pt), osmium (Os), gold (Au), titanium (Ti), zirconium (Zr), hafnium (Hf), europium (Eu), terbium (Tb), or thulium (Tm) may be used as a phosphorescent dopant. Specifically, FIrpic(iridium(III) bis(4,6-difluorophenylpyridinato-N,C2')picolinate), Fir6(Bis(2,4-difluorophenylpyridinato)-tetrakis(1-pyrazolyl)borate iridium(III)), or PtOEP(platinum octaethyl porphyrin) may be used as a phosphorescent dopant.

Each of the electron transport regions ETR1, ETR2, ETR3, and ETR4 may have a single-layered structure made of a single material, a single-layered structure made of different materials, or a multi-layered structure having layers made of different materials. For example, at least some of the electron transport regions ETR1, ETR2, ETR3, and ETR4 may include an electron transport layer ETL4 and an electron injection layer EIL4.

Each of the electron transport regions ETR1, ETR2, ETR3, and ETR4 may be formed by using various methods such as a vacuum deposition method, a spin coating method, a casting method, a Langmuir-Blodgett (LB) method, an inkjet printing method, a laser printing method, and a laser induced thermal imaging (LITI) method.

The electron transport regions ETR1, ETR2, ETR3, and ETR4 may include an anthracene-based compound. Without being limited thereto, however, each of the electron transport regions ETR1, ETR2, ETR3, and ETR4 may include, for example, Alq₃ (Tris(8-hydroxyquinolinato)aluminum), 1,3,5-tri[(3-pyridyl)-phen-3-yl]benzene, T2T(2,4,6-tris(3'-(pyridin-3-yl)biphenyl-3-yl)-1,3,5-triazine), 2-(4-(N-phenylbenzoimidazol-1-yl)phenyl)-9,10-dinaphthylanthracene, TPBi(1,3,5-Tri(1-phenyl-1H-benzo[d]imidazol-2-yl)benzene), BCP(2,9-Dimethyl-4,7-diphenyl-1,10-phenanthroline), Bphen(4,7-Diphenyl-1,10-phenanthroline), TAZ(3-(4-Biphenylyl)-4-phenyl-5-tert-butylphenyl-1,2,4-triazole), NTAZ(4-(Naphthalen-1-yl)-3,5-diphenyl-4H-1,2,4-triazole), tBu-PBD(2-(4-Biphenylyl)-5-(4-tert-butylphenyl)-1,3,4-oxadiazole), BAlq(Bis(2-methyl-8-quinolinolato-N1,O8)-(1,1'-Biphenyl-4-olato)aluminum), Bebq₂(berylliumbis(benzoquinolin-10-olate)), ADN(9,10-di(naphthalene-2-yl)anthracene), BmPyPhB(1,3-Bis[3,5-di(pyridin-3)-yl)phenyl]benzene), and mixtures thereof.

Each of the electron transport regions ETR1, ETR2, ETR3, and ETR4 may include a halogenated metal such as LiF, NaCl, CsF, RbCl, RbI, CuI, and KI, a lanthanide metal such as Yb, and a co-deposition material of the halogenated metal and the lanthanide metal. For example, the electron transport regions ETR1, ETR2, ETR3, and ETR4 may include KI:Yb, RbI:Yb, and the like as a co-deposited material. The electron transport regions ETR1, ETR2, ETR3, and ETR4 may include two or more materials selected from among Mg, Ag, Yb, and Al. For example, the electron transport regions ETR1, ETR2, ETR3, and ETR4 may include Mg and Yb.

The electron transport regions ETR1, ETR2, ETR3, and ETR4 may be made of a metal oxide such as Li₂O and BaO, Liq (8-hydroxyl-Lithium quinolate), or the like, but the embodiment of the invention is not limited thereto. Each of the electron transport regions ETR1, ETR2, ETR3, and ETR4 may also be made of a mixture of an electron transport material and an insulating organometallic salt. The organometallic salt may be a material having an energy band gap of about 4 eV or more. Specifically, for example, the organometallic salt may include metal acetate, metal benzoate, metal acetoacetate, metal acetylacetonate, or metal stearate.

Each of the electron transport regions ETR1, ETR2, ETR3, and ETR4 may further include at least one of BCP(2,9-dimethyl-4,7-diphenyl-1,10-phenanthroline) and Bphen(4,7-diphenyl-1,10-phenanthroline) in addition to the above-mentioned materials, but the embodiment of the invention is not limited thereto.

The electron transport regions ETR1, ETR2, ETR3, and ETR4 may include the compounds of the electron transport regions described above in the electron injection layer or the electron transport layer. In case that the electron transport regions ETR1, ETR2, ETR3, and ETR4 include an electron-side additional layer, the electron-side additional layer may include the above-described materials. In an embodiment of the invention, the electron injection layer EIL4 may be composed of two or more materials selected from among Mg, Ag, Yb, and Al. The electron injection layer EIL4 may be composed of, for example, a mixture of Mg and Yb.

The thickness of each of the electron transport regions ETR1, ETR2, ETR3, and ETR4 may be, for example, in a range of about 10 nm to about 150 nm. The thickness of the electron transport layer may be in a range of about 0.1 nm to about 100 nm, for example, in a range of about 0.3 nm to about 50 nm. In case that the thickness of the electron transport layer satisfies the range described above, satisfactory electron transport characteristics may be obtained without a substantial increase in driving voltage.

The second electrode EL2 may be provided on the light-emitting stacks ST1, ST2, ST3, and ST4. The second electrode EL2 may be a common electrode. The second electrode EL2 may be a cathode or an anode, but the embodiment of the invention is not limited thereto. For example, in case that the first electrode EL1 is an anode, the second electrode EL2 may be a cathode, and in case that the first electrode EL1 is a cathode, the second electrode EL2 may be an anode.

The second electrode EL2 may be a semi-transmissive electrode or a transmissive electrode. In case that the second electrode EL2 is a transmissive electrode, the second electrode EL2 is made of a transparent metal oxide such as indium tin oxide (ITO), indium zinc oxide (IZO), zinc oxide (ZnO), and indium tin zinc oxide (ITZO).

In case that the second electrode EL2 is a semi-transmissive electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, In, Zn, Sn, or a compound or mixture containing them (e.g., AgMg, AgYb, or MgAg). As another example, the second electrode EL2 may have a multi-layered structure including a reflective or semi-transmissive film formed of the above materials and a transparent conductive film formed of indium tin oxide (ITO), indium zinc oxide (IZO), zinc oxide (ZnO), indium tin zinc oxide (ITZO), or the like. For example, the second electrode EL2 may include one of the aforementioned metal materials, a combination of two or more metal materials selected from among the aforementioned metal materials, an oxide of the aforementioned metal materials, or the like.

Although not illustrated, the second electrode EL2 may be connected to an auxiliary electrode. In case that the second electrode EL2 is connected to the auxiliary electrode, the resistance of the second electrode EL2 may be reduced.

A capping layer CPL may be further disposed on the second electrode EL2 of the light-emitting element LED according to an embodiment of the invention. The capping layer CPL may include layers or a single layer.

In an embodiment of the invention, the capping layer CPL may be an organic layer or an inorganic layer. For example, in case that the capping layer CPL includes an inorganic material, the inorganic material may include an alkali metal compound such as LiF, an alkaline earth metal compound such as MgF₂, SiON, SiNₓ, SiO_{y}, etc.

For example, in case that the capping layer CPL includes an organic material, the organic material may include α-NPD, NPB, TPD, m-MTDATA, Alq₃, CuPc, TPD15(N4,N4,N4',N4'-tetra (biphenyl-4-yl) biphenyl-4,4'-diamine), TCTA (4,4',4"- Tris (carbazol sol-9-yl) triphenylamine), and the like, or include epoxy resin or acrylate such as methacrylate.

The refractive index of the capping layer CPL may be about 1.6 or more. Specifically, the refractive index of the capping layer CPL may be about 1.6 or more with respect to light in a wavelength range of about 550 nm to about 660 nm.

Referring again to FIG. 4A, in the light-emitting element LED according to an embodiment of the invention, the electron control layer ETR may be disposed between the light-emitting layer EML and the second electrode EL2. The electron control layer ETR may include at least one of an electron injection layer, an electron transport layer, and a hole blocking layer. Referring to FIG. 4A, the electron control layer ETR may be disposed as a common layer so as to entirely overlap the light-emitting regions EA1, EA2, and EA3 and the pixel defining film PDL that separates the light-emitting regions EA1, EA2, and EA3. However, the embodiment of the invention is not limited thereto, and the electron control layer ETR may be patterned and provided so as to be separately disposed to correspond to each of the light-emitting regions EA1, EA2, and EA3.

The second electrode EL2 may be provided on the electron control layer ETR. The second electrode EL2 may be a common electrode. The second electrode EL2 may be a cathode or an anode, but the embodiment of the invention is not limited thereto. For example, in case that the first electrode EL1 is an anode, the second electrode EL2 may be a cathode, and when the first electrode EL1 is a cathode, the second electrode EL2 may be an anode. The second electrode EL2 may be a transmissive electrode, a semi-transmissive electrode, or a reflective electrode.

The thin-film encapsulation layer TFE may be disposed on the light-emitting element LED. For example, in an embodiment of the invention, the thin-film encapsulation layer TFE may be disposed on the second electrode EL2. In case that the light-emitting element LED includes a capping layer (not illustrated), the thin-film encapsulation layer TFE may be disposed on the capping layer (not illustrated). As described above, the thin-film encapsulation layer TFE may include at least one organic layer and at least one inorganic layer, and the inorganic layer and the organic layer may be alternately disposed.

The display panel DP according to an embodiment of the invention may include an optical structure layer OSL disposed on the display element layer DP-LED. The optical structure layer OSL may include a light control layer CCL, a color filter layer CFL, and a base layer BL.

The light control layer CCL may include a light converter. The light converter may be a quantum dot, a phosphor, or the like. The light converter may convert the wavelength of received light and emit the converted light. For example, the light control layer CCL may be a layer at least partially including a quantum dot or a phosphor.

The light control layer CCL may include light control patterns CCP-R, CCP-G, and CCP-B. The light control patterns CCP-R, CCP-G, and CCP-B may be spaced apart from each other. The light control patterns CCP-R, CCP-G, and CCP-B may be disposed to be spaced apart from each other by the bank BMP. The light control patterns CCP-R, CCP-G, and CCP-B may be disposed in bank openings BOH1, BOH2, and BOH3 defined in the bank BMP. However, the embodiment of the invention is not limited thereto. In FIG. 4A, the bank BMP is illustrated as having a rectangular shape and non-overlapping the light control patterns CCP-R, CCP-G, and CCP-B on a cross section, but the edges of some of the light control patterns CCP-R, CCP-G, and CCP-B may at least partially overlap the bank BMP. For example, the edge of the third light control pattern CCP-B may be disposed to overlap the bank BMP on a plane. The bank BMP may have a trapezoidal shape on a cross section. The bank BMP may have a shape in which the cross-sectional width of the bank BMP increases as it approaches the display element layer DP-LED.

The light control patterns CCP-R, CCP-G, and CCP-B may convert the wavelength of light provided from the display element layer DP-LED or transmit the light provided.

The light control layer CCL may include a first light control pattern CCP-R that provides red light as first light, a second light control pattern CCP-G that provides green light as second light, and a third light control pattern CCP-B that provides blue light as third light. The light control layer CCL may include a first light control pattern CCP-R that converts source light provided from the light-emitting element LED into first light, a second light control pattern CCP-G that converts source light into second light, and a third light control pattern CCP-B that transmits source light. At least some of the light control patterns CCP-R, CCP-G, and CCP-B may include a quantum dot that converts source light into light of a specific wavelength.

Some of the light control patterns CCP-R, CCP-G, and CCP-B may be formed through an inkjet process. In an embodiment of the invention, the first light control pattern CCP-R and the second light control pattern CCP-G may be formed through an inkjet process. A liquid ink composition may be provided inside each of the first bank opening BOH1 and the second bank opening BOH2, and the provided ink composition may be polymerized through a thermal curing process or a light curing process to form the first light control pattern CCP-R and the second light control pattern CCP-G. The others of the light control patterns CCP-R, CCP-G, and CCP-B may be formed through a photoresist process. In an embodiment of the invention, the third light control pattern CCP-B may be formed through a photoresist process. After a photoresist composition is provided in at least the third bank opening BOH3, the third light control pattern CCP-B may be formed by curing the provided photoresist composition.

The light control layer CCL may further include a scatterer. The first light control pattern CCP-R may include a first quantum dot and a scatterer, the second light control pattern CCP-G may include a second quantum dot and a scatterer, and the third light control pattern CCP- B may not include a quantum dot, but may include a scatterer. Each of the first light control pattern CCP-R, the second light control pattern CCP-G, and the third light control pattern CCP-B may further include a base resin that disperses quantum dots and scatterers. As the third light control pattern CCP-B is formed through a photoresist process which will be described below, the third light control pattern CCP-B may include a photosensitive resin.

The light control layer CCL may include a first barrier layer CAP1 disposed on a side of the first light control pattern CCP-R. The light control layer CCL may include a first barrier layer CAP1 spaced apart from the display element layer DP-LED with the light control patterns CCP-R, CCP-G and CCP-B interposed therebetween and a second barrier layer CAP2 adjacent to the display element layer DP-LED.

In the display panel DP, the optical structure layer OSL may include a color filter layer CFL disposed on the light control layer CCL. The color filter layer CFL may include color filters CF1, CF2, and CF3. The color filter layer CFL may include a first color filter CF1 configured to transmit first light, a second color filter CF2 configured to transmit second light, and a third color filter CF3 configured to transmit source light. In an embodiment of the invention, the first color filter CF1 may be a red filter, the second color filter CF2 may be a green filter, and the third color filter CF3 may be a blue filter.

Each of the color filters CF1, CF2, and CF3 may include a polymer photosensitive resin and a colorant. The first color filter CF1 may include a red colorant, the second color filter CF2 may include a green colorant, and the third color filter CF3 may include a blue colorant. The first color filter CF1 may include a red pigment or a red dye, the second color filter CF2 may include a green pigment or a green dye, and the third color filter CF3 may include a blue pigment or a blue dye.

The first to third color filters CF1, CF2, and CF3 may be respectively disposed to correspond to the first pixel region PXA-R, the second pixel region PXA-G, and the third pixel region PXA-B. The first to third color filters CF1, CF2, and CF3 may be respectively disposed to correspond to the first to third light control patterns CCP-R, CCP-G, and CCP-B.

In the peripheral region NPXA disposed between the pixel regions PXA-R, PXA-G, and PXA-B, the color filters CF1, CF2, and CF3 configured to transmit different light may be disposed to overlap each other. The color filters CF1, CF2, and CF3 may be disposed to overlap each other in the third direction DR3, which is the thickness direction, so as to demarcate boundaries between adjacent pixel regions PXA-R, PXA-G, and PXA-B. Unlike what is illustrated, the color filter layer CFL may include a light blocking portion (not illustrated) to demarcate boundaries between adjacent color filters CF1, CF2, and CF3. The light blocking portion (not illustrated) may be formed of a blue filter, or may be formed by including an inorganic light blocking material or an organic light blocking material including a black pigment or a black dye.

The optical structure layer OSL may include a filling layer FML disposed between the light control layer CCL and the color filter layer CFL. The filling layer FML may be disposed between the light control patterns CCP-R, CCP-G, and CCP-B and the color filters CF1, CF2, and CF3. The filling layer FML may be disposed on the light control layer CCL to block the light control patterns CCP-R, CCP-G, and CCP-B from being exposed to moisture or oxygen. By being disposed between the light control patterns CCP-R, CCP-G, and CCP-B and the color filters CF1, CF2, and CF3, the filling layer FML may function as an optical functional layer to increase light extraction efficiency or prevent reflected light from being incident on the light control layer CCL. The filling layer FML may have a lower refractive index than other adjacent layers.

In an embodiment of the invention, the optical structure layer OSL may further include a base layer BL disposed on the color filter layer CFL. The base layer BL may be a member that provides a base surface on which a color filter layer CFL and a light control layer CCL are disposed. For example, the base layer BL may be a glass substrate, a metal substrate, or a plastic substrate. However, the embodiment of the invention is not limited thereto, and the base layer BL may be an inorganic layer, an organic layer, or a composite material layer. Unlike what is illustrated, in an embodiment of the invention, the base layer BL may be omitted.

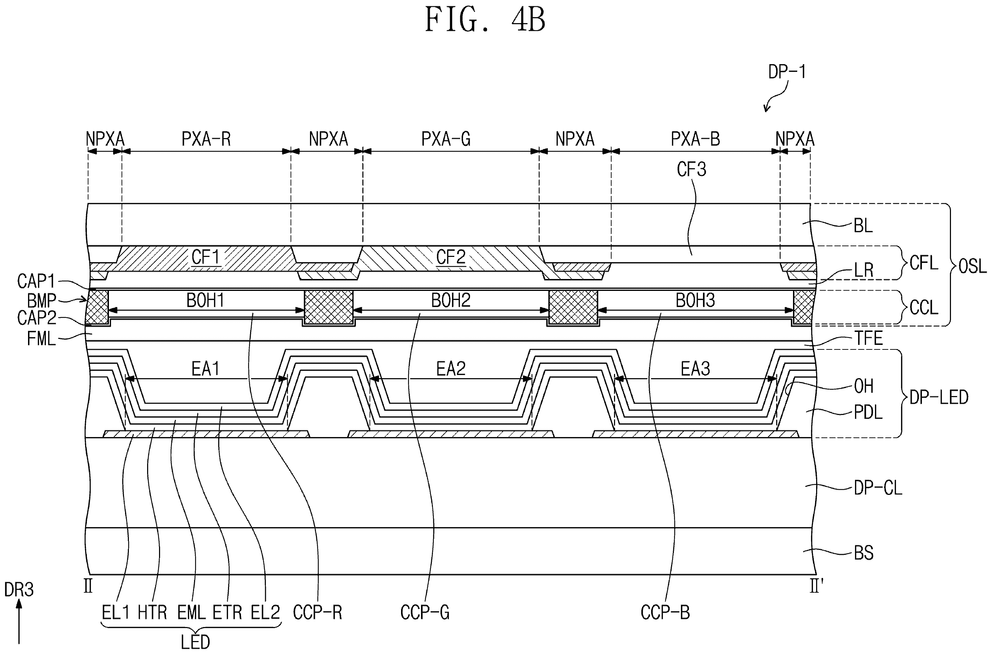

FIGS. 4B to 4D respectively illustrate display panels DP-1, DP-2, and DP-3 according to an embodiment of the invention, which are different from the display panel DP according to an embodiment of the invention, which is illustrated in FIG. 4A.

Referring to FIG. 4B, a display panel DP-1 according to an embodiment of the invention may include a lower panel including a base substrate BS, a circuit element layer DP-CL disposed on the base substrate BS, and a display element layer DP-LED disposed on the circuit element layer DP-CL, and an optical structure layer OSL disposed on the lower panel. The optical structure layer OSL may include a light control layer CCL, a color filter layer CFL, and a base layer BL.

The display panel DP-1 according to an embodiment of the invention may include a lower panel including a display element layer DP-LED and an upper panel (optical structure layer OSL) including a light control layer CCL and a color filter layer CFL, and in an embodiment of the invention, a filling layer FML may be disposed between the lower panel and the upper panel OSL.

In an embodiment of the invention, the filling layer FML may fill a space between the display element layer DP-LED and the light control layer CCL. The filling layer FML may be disposed directly on the thin-film encapsulation layer TFE, and the second barrier layer CAP2 may be disposed directly on the filling layer FML. The lower surface of the filling layer FML may contact the upper surface of the thin-film encapsulation layer TFE, and the upper surface of the filling layer FML may contact the lower surface of the second barrier layer CAP2.

The filling layer FML may function as a buffer between the display element layer DP-LED and the light control layer CCL. In an embodiment of the invention, the filling layer FML may perform a shock absorbing function and the like and increase the strength of the display panel DP-1. In an embodiment, the filling layer FML may be formed from a filling resin including a polymer resin. For example, the filling layer FML may be formed from a filling resin including an acrylic-based resin, an epoxy-based resin, or the like.

Compared to the display panel DP illustrated in FIG. 4A, the display panel DP-1 according to an embodiment of the invention, which is illustrated in FIG. 4B, is an embodiment in which the filling layer FML is disposed between the display element layer DP-LED and the light control layer CCL. For example, in the display panel DP-1 of FIG. 4B, the circuit element layer DP-CL and the display element layer DP-LED, as a lower panel, may be disposed on the upper surface of the base substrate BS used as a base surface, and the color filter layer CFL and the light control layer CCL, as an upper panel (optical structure layer OSL), may be disposed on the upper surface of the base layer BL used as a base surface, and the display panel DP-1 may be formed by coupling the lower panel and the upper panel to each other with the filling layer FML interposed therebetween.

In the display panel DP-1 according to an embodiment of the invention, a step difference or height difference may occur between the lower surface of the bank BMP and the lower surface of the light control patterns CCP-R, CCP-G, and CCP-B. For example, the lower surface of the bank BMP may be defined to be higher than the lower surface of the light control patterns CCP-R, CCP-G, and CCP-B. The height difference between the lower surface of the bank BMP and the lower surface of the light control patterns CCP-R, CCP-G, and CCP-B may be, for example, in a range of about 2 µm to about 3 µm.

The second barrier layer CAP2 may be disposed to follow the step difference between the bank BMP and the light control patterns CCP-R, CCP-G, and CCP-B. The second barrier layer CAP2 may be disposed directly on the filling layer FML.

The display panel DP-1 according to an embodiment of the invention may include a low refractive layer LR. The low refractive layer LR may be disposed between the light control layer CCL and the color filter layer CFL. The low refractive layer LR may be disposed above the light control layer CCL to block the light control patterns CCP-R, CCP-G, and CCP-B from being exposed to moisture/oxygen. By being disposed between the light control patterns CCP-R, CCP-G, and CCP-B and the color filters CF1, CF2, and CF3, the low refractive layer LR may also function as an optical functional layer to increase light extraction efficiency or prevent reflected light from being incident on the light control layer CCL. The low refractive layer LR may have a lower refractive index than adjacent layers.

The low refractive layer LR may include at least one inorganic layer. For example, the low refractive layer LR may include silicon nitride, aluminum nitride, zirconium nitride, titanium nitride, hafnium nitride, tantalum nitride, silicon oxide, aluminum oxide, titanium oxide, tin oxide, cerium oxide, silicon oxynitride, a metal thin film having a secured light transmittance, or the like. However, the embodiment of the invention is not limited thereto, and the low refractive layer LR may include an organic layer. For example, the low refractive layer LR may have a structure in which hollow particles are dispersed in an organic polymer resin. The low refractive layer LR may be composed of a single layer or layers.

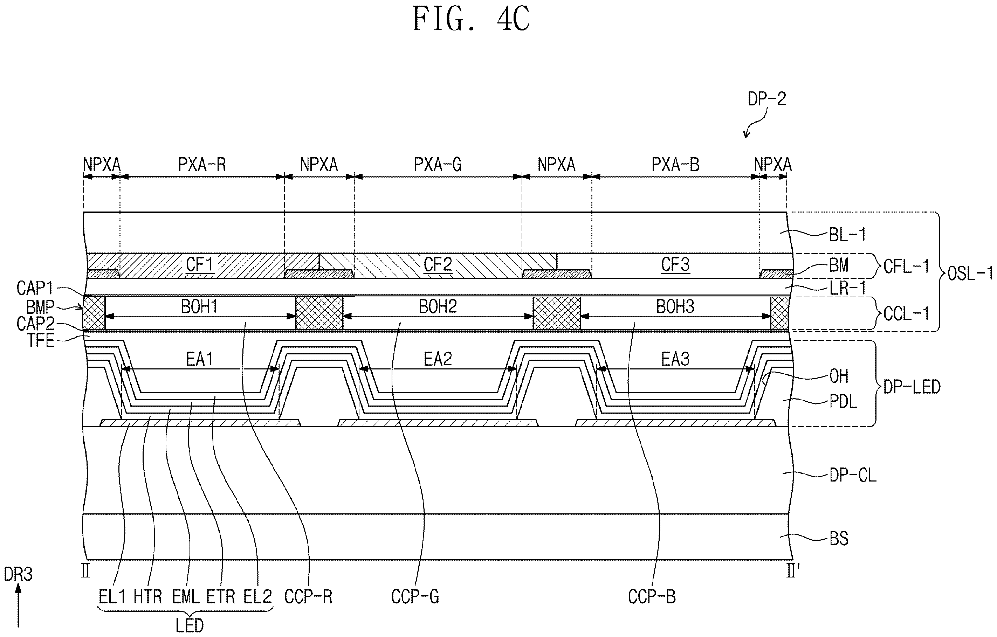

Referring to FIG. 4C, a display panel DP-2 according to an embodiment of the invention may include a lower panel including a base substrate BS, a circuit element layer DP-CL disposed on the base substrate BS, and a display element layer DP-LED disposed on the circuit element layer DP-CL, and an optical structure layer OSL-1 disposed on the lower panel. In the display panel DP-2 according to an embodiment of the invention, the optical structure layer OSL-1 may include a light control layer CCL-1, a low refractive layer LR-1, a color filter layer CFL-1, and a base layer BL-1 which are sequentially stacked on a thin-film encapsulation layer TFE. The optical structure layer OSL-1 may include a first barrier layer CAP1 and a second barrier layer CAP2 which are disposed on the upper and lower surfaces of the light control layer CCL-1.

The light control layer CCL-1 may be disposed above the display element layer DP-LED and the thin-film encapsulation layer TFE with the second barrier layer CAP2 interposed therebetween. The light control layer CCL-1 may include banks BMP and light control patterns CCP-R, CCP-G, and CCP-B disposed between the banks BMP. A low refractive layer LR-1 may be disposed on the light control layer CCL-1.

The color filter layer CFL-1 may include color filters CF1, CF2, and CF3 and a light blocking portion BM.

Compared to the display panel DP-1 illustrated in FIG. 4B, the display panel DP-2 according to an embodiment of the invention, which are illustrated in FIG. 4C, is an embodiment in which the light control layer CCL-1, the low refractive layer LR-1, and the color filter layer CFL-1 are disposed on the upper surface of the thin-film encapsulation layer TFE used as a base surface. For example, the light control patterns CCP-R, CCP-G, and CCP-B of the light control layer CCL-1 may be formed on the thin-film encapsulation layer TFE in a continuous process, and the color filters CF1, CF2, and CF3 of the color filter layer CFL-1 may be sequentially formed on the light control layer CCL-1 through a continuous process. The light control layer CCL-1 may be formed on the upper surface of the second barrier layer CAP2, which is disposed on the thin-film encapsulation layer TFE and used as a base surface, and may have a shape that is inverted vertically compared to the shape of the light control layer CCL illustrated in FIG. 4A. Specifically, each of the banks BMP and the light control patterns CCP-R, CCP-G, and CCP-B may have a shape that is inverted vertically compared to what is illustrated in FIG. 4A. The color filter layer CFL-1 may be formed on the upper surface of the light control layer CCL-1 used as a base surface and may have a shape different from what is illustrated in FIG. 4A.

In the color filter layer CFL-1 according to an embodiment of the invention, the light blocking portion BM may be a black matrix. The light blocking portion BM may be formed of an inorganic light blocking material or an organic light blocking material including a black pigment or a black dye. The light blocking portion BM may prevent light leakage and demarcate boundaries between adjacent color filters CF1, CF2, and CF3.

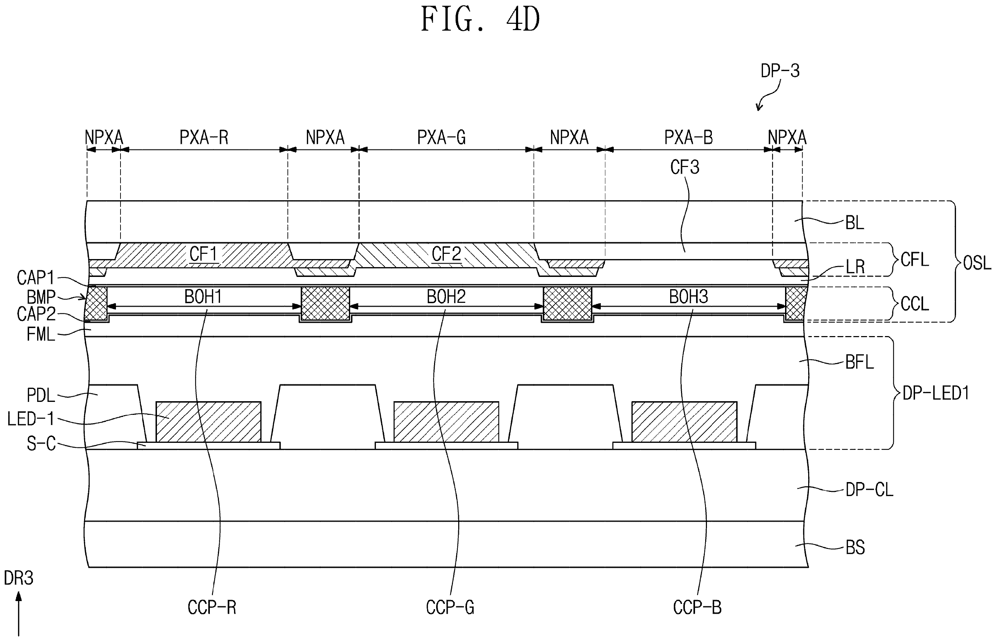

Referring to FIG. 4D, a display element layer DP-LED1 included in a display panel DP-3 according to an embodiment of the invention may include a light-emitting element LED-1, and the light-emitting element LED-1 may be a micro LED element or a nano LED element. The light-emitting element LED-1 may be disposed between portions of the pixel defining film PDL and may be electrically connected to a contact portion S-C, and the length and width of the light-emitting element LED-1 may be about hundreds of nanometers to about hundreds of micrometers. The light-emitting element LED-1 may be an LED element including an active layer and at least one semiconductor material layer. The light-emitting element LED-1 may further include an insulating layer covering the surfaces of the active layer and the semiconductor material layer. The light-emitting element LED-1 may be patterned and disposed to overlap each of the pixel regions PXA-R, PXA-G, and PXA-B. The display panel DP-3 may include a buffer layer BFL disposed on the light-emitting element LED-1. The buffer layer BFL may be disposed on and cover the light-emitting element LED-1. In the display panel DP-3 according to an embodiment of the invention, which is illustrated in FIG. 4D, the buffer layer BFL may be omitted.

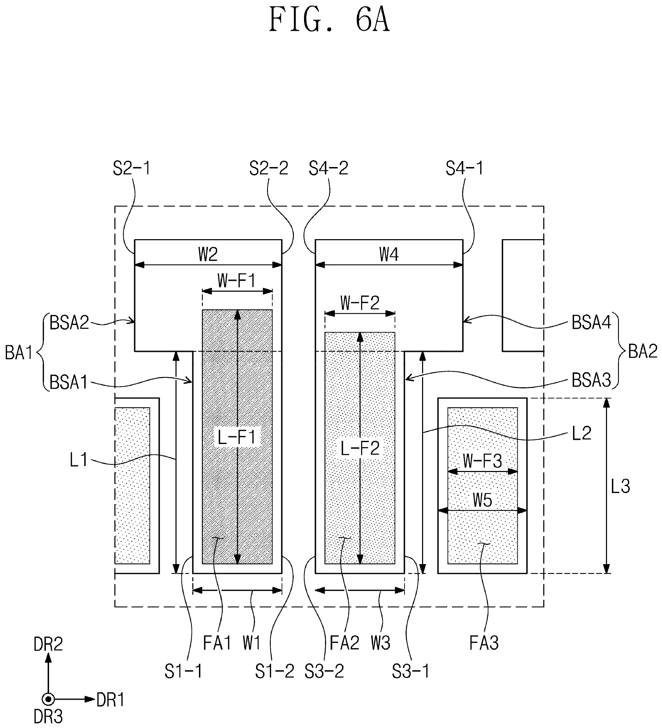

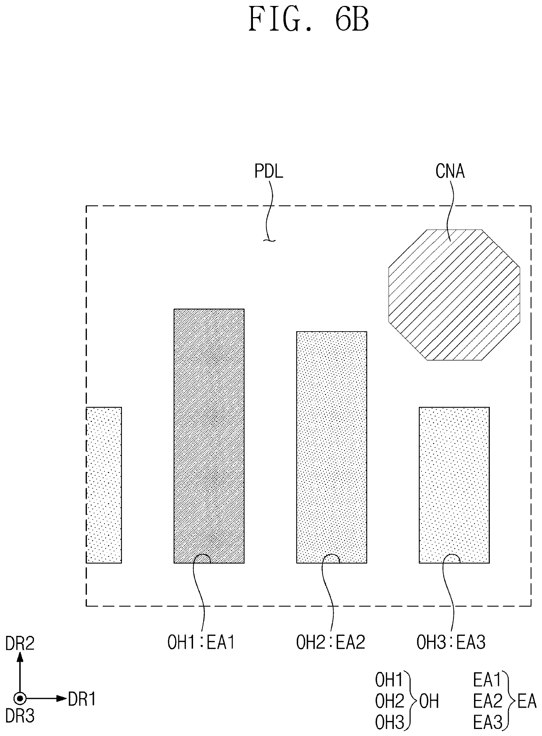

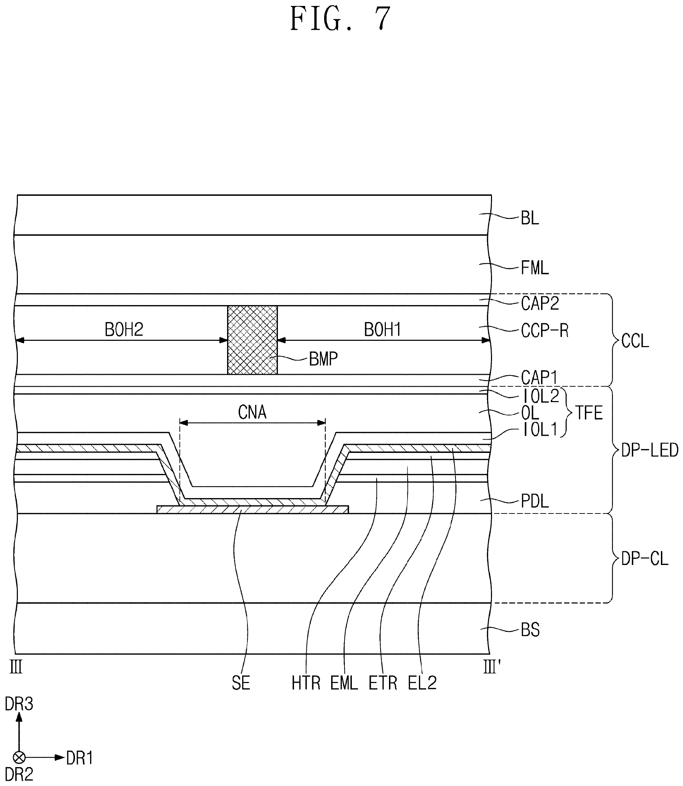

FIG. 6A is a schematic enlarged plan view of a portion of the display panel according to an embodiment of the invention. FIG. 6B is a schematic enlarged plan view of a portion of the display panel according to an embodiment of the invention. FIG. 7 is a schematic cross-sectional view of a portion of the display panel according to an embodiment of the invention. Among the display region DA illustrated in FIG. 2, FIG. 6A illustrates the arrangement shape of the filter regions FA1, FA2, and FA3 and the bank openings BOH1, BOH2, and BOH3 on a plane corresponding to a first filter region FA1, a second filter region FA2, and a third filter region FA3. FIG. 6B illustrates the planar shape of the light-emitting opening OH formed in the pixel defining film PDL and the light-emitting regions EA1, EA2, and EA3 defined by the light-emitting opening OH on a plane corresponding to FIG. 6A. FIG. 7 illustrates a cross section corresponding to line III-III' illustrated in FIG. 2.

Referring to FIGS. 2, 3, 4A, and 6A, the first to third filter regions FA1, FA2, and FA3 may respectively correspond to the above-described first to third pixel regions PXA-R, PXA-G, and PXA-B and may be defined by the color filters CF1, CF2, and CF3. The first filter region FA1 may be defined by the first color filter CF1, the second filter region FA2 may be defined by the second color filter CF2, and the third filter region FA3 may be defined by the third color filter CF3. The first filter region FA1 may overlap the first color filter CF1 and may not overlap the second color filter CF2 and the third color filter CF3. The second filter region FA2 may overlap the second color filter CF2 and may not overlap the first color filter CF1 and the third color filter CF3. The third filter region FA3 may overlap the third color filter CF3 and may not overlap the first color filter CF1 and the second color filter CF2.

Each of the first to third filter regions FA1, FA2, and FA3 may have a rectangular shape. Each of the first to third filter regions FA1, FA2, and FA3 may have a rectangular shape with a short side extending in the first direction DR1 and a long side extending in the second direction DR2. The areas of the first to third filter regions FA1, FA2, and FA3 may be set according to the colors of emitted light. The area of the first filter region FA1 that emits red light may be the largest, and the area of the third filter region FA3 that emits blue light may be the smallest.

The bank opening BOH defined in the bank BMP may include a first bank opening BOH1, a second bank opening BOH2, and a third bank opening BOH3. A first light control pattern CCP-R may be disposed in the first bank opening BOH1, a second light control pattern CCP-G may be disposed in the second bank opening BOH2, and a third light control pattern CCP-B may be disposed in the third bank opening BOH3. In this specification, a region defined by the first bank opening BOH1 may be described as a first bank region BA1, a region defined by the second bank opening BOH2 may be described as a second bank region BA2, and a region defined by the third bank opening BOH3 may be described as a third bank region BA3.

In an embodiment of the invention, the first bank region BA1 may include a first sub-region BSA1 and a second sub-region BSA2. The first sub-region BSA1 and the second sub-region BSA2 may have an integral shape and may be connected to each other. The first light control pattern CCP-R may be disposed in the first bank opening BOH1 defining each of the first sub-region BSA1 and the second sub-region BSA2. For example, the first light control pattern CCP-R may be disposed to overlap the first sub-region BSA1 and the second sub-region BSA2.

The first sub-region BSA1 may have a first width W1 in the first direction DR1, and the second sub-region BSA2 may have a second width W2 greater than the first width W1 in the first direction DR1. For example, the second sub-region BSA2 may have a larger width than the first sub-region BSA1 in the first direction DR1. The length of the second sub-region BSA2 in the second direction DR2 may be smaller than the length of the first sub-region BSA1 in the second direction DR2. In other words, the second sub-region BSA2 may have a shorter length than the first sub-region BSA1 in the second direction DR2. The first width W1 may be in a range of about 25 micrometers to about 30 micrometers, and the second width W2 may be in a range of about 35 micrometers to about 50 micrometers.

The first filter region FA1 may overlap the first sub-region BSA1 and a portion of the second sub-region BSA2. The first filter region FA1 may have a first filter width W-F1 in the first direction DR1, and the first filter width W-F1 may be smaller than the first width W1. The first sub-region BSA1 may have a first length L1 in the second direction DR2, the first filter region FA1 may have a first filter length L-F1 in the second direction DR2, and the first filter length L-F1 may be greater than the first length L1. For example, the first filter region FA1 may be disposed to overlap the first sub-region BSA1 except for a portion of the outer region of the first sub-region BSA1, and the length of the first filter region FA1 in the second direction DR2 may be greater than the length of the first sub-region BSA1 in the second direction DR2. Therefore, a portion of the first filter region FA1 may be disposed to extend to the second sub-region BSA2.

A portion of the second sub-region BSA2 may include a portion that does not overlap the first filter region FA1. A connection region CNA, which will be described below, may overlap the portion of the second sub-region BSA2 that does not overlap the first filter region FA1.

The first sub-region BSA1 may include a (1-1)-th side S1-1 and a (1-2)-th side S1-2 spaced apart from each other in the first direction DR1. The second sub-region BSA2 may include a (2-1)-th side S2-1 and a (2-2)-th side S2-2 spaced apart from each other in the first direction DR1. The above-described first width W1 may be the separation distance between the (1-1)-th side S1-1 and the (1-2)-th side S1-2, and the above-described second width W2 may be the separation distance between the (2-1)-th side S2-1 and the (2-2)-th side S2-2.

Based on the second direction DR2, the (1-2)-th side S1-2 and the (2-2)-th side S2-2 may be parallel to each other. For example, the (1-2)-th side S1-2 and the (2-2)-th side S2-2 may define a side extending in the second direction DR2. The first sub-region BSA1 and the second sub-region BSA2 may have different widths as the separation distance between the (1-2)-th side S1-2 and the (1-1)-th side S1-1 and the separation distance between the (2-2)-th side S2-2 and the (2-1)-th side S2-1 are different from each other, and the (1-2)-th side S1-2 and the (2-2)-th side S2-2 may extend on a same straight line.

In an embodiment of the invention, the second bank region BA2 may include a third sub-region BSA3 and a fourth sub-region BSA4. The third sub-region BSA3 and the fourth sub-region BSA4 may have an integral shape and may be connected to each other. The second light control pattern CCP-G may be disposed in the second bank opening BOH2 defining each of the third sub-region BSA3 and the fourth sub-region BSA4. For example, the second light control pattern CCP-G may be disposed to overlap the third sub-region BSA3 and the fourth sub-region BSA4.

The third sub-region BSA3 may have a third width W3 in the first direction DR1, and the fourth sub-region BSA4 may have a fourth width W4 greater than the third width W3 in the first direction DR1. For example, the fourth sub-region BSA4 may have a larger width than the third sub-region BSA3 in the first direction DR1. The length of the fourth sub-region BSA4 in the second direction DR2 may be smaller than the length of the third sub-region BSA3 in the second direction DR2. In other words, the fourth sub-region BSA4 may have a shorter length than the third sub-region BSA3 in the second direction DR2. The third width W3 may be in a range of about 25 micrometers to about 30 micrometers, and the fourth width W4 may be in a range of about 35 micrometers to about 50 micrometers. The third width W3 may be at least substantially equal to the above-described first width W1. The fourth width W4 may be at least substantially equal to the above-described second width W2.

The second filter region FA2 may overlap the third sub-region BSA3 and a portion of the fourth sub-region BSA4. The second filter region FA2 may have a second filter width W-F2 in the first direction DR1, and the second filter width W-F2 may be smaller than the third width W3. The third sub-region BSA3 may have a second length L2 in the second direction DR2, the second filter region FA2 may have a second filter length L-F2 in the second direction DR2, and the second filter length L-F2 may be larger than the second length L2. For example, the second filter region FA2 may be disposed to overlap the third sub-region BSA3 except for a portion of the outer region of the third sub-region BSA3, and the length of the second filter region FA2 in the second direction DR2 may be greater than the length of the third sub-region BSA3 in the second direction DR2. Therefore, a portion of the second filter region FA2 may be disposed to extend to the fourth sub-region BSA4.

The fourth sub-region BSA4 may include a portion that does not overlap the second filter region FA2. A connection region CNA, which will be described below, may overlap the portion of the fourth sub-region BSA4 that does not overlap the second filter region FA2.

The third sub-region BSA3 may include a (3-1)-th side S3-1 and a (3-2)-th side S3-2 spaced apart from each other in the first direction DR1. The fourth sub-region BSA4 may include a (4-1)-th side S4-1 and a (4-2)-th side S4-2 spaced apart from each other in the first direction DR1. The above-described third width W3 may be the separation distance between the (3-1)-th side S3-1 and the (3-2)-th side S3-2, and the above-described fourth width W4 may be the separation distance between the (4-1)-th side S4-1 and the (4-2)-th side S4-2.

Based on the second direction DR2, the (3-2)-th side S3-2 and the (3-1)-th side S3-1 may be parallel to each other. For example, the (3-2)-th side S3-2 and the (3-1)-th side S3-1 may define a side extending in the second direction DR2. The third sub-region BSA3 and the fourth sub-region BSA4 may have different widths as the separation distance between the (3-2)-th side S3-2 and the (3-1)-the side S3-1 and the separation distance between the (4-2)-th side S4-2 and the (4-1)-th side S4-1 are different from each other, and the (3-2)-th side S3-2 and the (4-2)-th side S4-2 may extend on a same straight line.

In an embodiment of the invention, the third bank region BA3 may have a fifth width W5 in the first direction DR1 and a third length L3 in the second direction DR2. The third filter region FA3 may overlap the third bank region BA3. The third bank region BA3 may have a rectangular shape on a plane.

The fifth width W5 may be at least substantially equal to the first width W1 of the first sub-region BSA1. The fifth width W5 may be at least substantially equal to the third width W3 of the third sub-region BSA3. For example, the width of each of the first sub-region BSA1, the third sub-region BSA3, and the third bank region BA3 in the first direction DR1 may be constant. In this specification, being "substantially equal to" or "at least substantially equal to" includes not only a case in which lengths, widths, areas, or the like are physically the same as each other, but also a case in which there is a difference equal to a process error that occurs despite a same design.

The third length L3 may be shorter than the first length L1 and the second length L2. The first length L1 and the second length L2 may be at least substantially equal to each other.

The third filter region FA3 may have a third filter width W-F3 in the first direction DR1, and the third filter width W-F3 may be smaller than the fifth width W5. The third bank region BA3 may have a third length L3 in the second direction DR2, and the third filter region FA3 may have a shorter length in the second direction DR2 than the third length L3.

In an embodiment of the invention, the first bank region BA1, the second bank region BA2, and the third bank region BA3 may be sequentially arranged in the first direction DR1. The separation distance between the first sub-region BSA1, the third sub-region BSA3, and the third bank region BA3 in the first direction DR1 may be constant. In an embodiment of the invention, a first separation distance d1 between the first sub-region BSA1 and the third sub-region BSA3 adjacent to each other, a second separation distance d2 between the third sub-region BSA3 and the third bank region BA3 adjacent to each other, and a third separation distance d3 between the third bank region BA3 and the first sub-region BSA1 adjacent to each other may be at least substantially equal to each other. Each of the first separation distance d1, the second separation distance d2, and the third separation distance d3 may be in a range of about 8 micrometers to about 13 micrometers.

In the display panel according to an embodiment of the invention, the first bank region defined by the first bank opening in which the first light control pattern is disposed may include a first sub-region having a first width and a second sub-region having a second width greater than the first width. The second bank region defined by the second bank opening in which the second light control pattern is disposed may include a third sub-region having a third width and a fourth sub-region having a fourth width greater than the third width. As the display panel according to an embodiment of the invention has a structure of a first filter region and a second filter region respectively overlapping the first and second sub-regions which have relatively narrow widths, the sizes of pixel regions may be reduced, thus making it possible to implement high resolution. As it is possible to secure an inkjet process impact region (or a region to inkjet process) for respectively forming a first light control pattern and a second light control pattern through the second sub-region and the fourth sub-region having wide widths, process efficiency for forming the first light control pattern and the second light control pattern may be improved.

Referring to FIGS. 2, 6B, and 7, in the display panel according to an embodiment of the invention, the display region DA may further include a connection region CNA.

The connection region CNA may overlap a portion of each of the first bank region BA1 and the second bank region BA2. The connection region CNA may overlap a portion of each of the second sub-region BSA2 and the fourth sub-region BSA4.

As illustrated in FIG. 6B, a light-emitting opening OH may be defined in the pixel defining film PDL, and the light-emitting opening OH may include a first light-emitting opening OH1, a second light-emitting opening OH2, and a third light-emitting opening OH3. In this embodiment, the above-described light-emitting region EA may be defined by the light-emitting opening OH. The first light-emitting region EA1 may be defined by the first light-emitting opening OH1, the second light-emitting region EA2 may be defined by the second light-emitting opening OH2, and the third light-emitting region EA3 may be defined by the third light-emitting opening OH3. The first light-emitting region EA1, the second light-emitting region EA2, and the third light-emitting region EA3 may respectively correspond to the first filter region FA1, the second filter region FA2, and the third filter region FA3 described above in FIG. 6A. The connection region CNA may not overlap each of the first light-emitting region EA1, the second light-emitting region EA2, and the third light-emitting region EA3. The connection region CNA may not overlap each of the first filter region FA1, the second filter region FA2, and the third filter region FA3 which are described above.

Referring to FIGS. 2, 6B, and 7, the connection region CNA may be a region in which an auxiliary electrode SE and a second electrode EL2 are connected to each other. The auxiliary electrode SE may be disposed on the circuit element layer DP-CL. The auxiliary electrode SE and the above-described first electrode EL1 (see FIG. 3) may include a same material and may be formed on the circuit element layer DP-CL through a same process. The connection region CNA may be a portion in which the second electrode EL2 is connected to the auxiliary electrode SE by removing organic layers such as the hole control layer HTR, the light-emitting layer EML, and the electron control layer ETR included in the light-emitting element through a laser drilling process. The auxiliary electrode SE may be a conductive pattern to which a power voltage is applied.

The connection region CNA may overlap the bank BMP and may also overlap a portion of the first bank opening BOH1 and a portion of the second bank opening BOH2. As described above, since the connection region CNA does not overlap each of the first filter region FA1, the second filter region FA2, and the third filter region FA3, which are described above, the color filters CF1, CF2, and CF3 (see FIG. 4A) may not overlap the connection region CNA. In the display panel according to an embodiment of the invention, since the connection region CNA overlaps each of the first bank opening BOH1 and the second bank opening BOH2 and does not overlap the first filter region FA1, the second filter region FA2, and the third filter region FA3, it is possible to secure a wide inkjet process impact region while securing the aperture ratio of the pixel region, thereby improving the process efficiency of manufacturing the display panel.

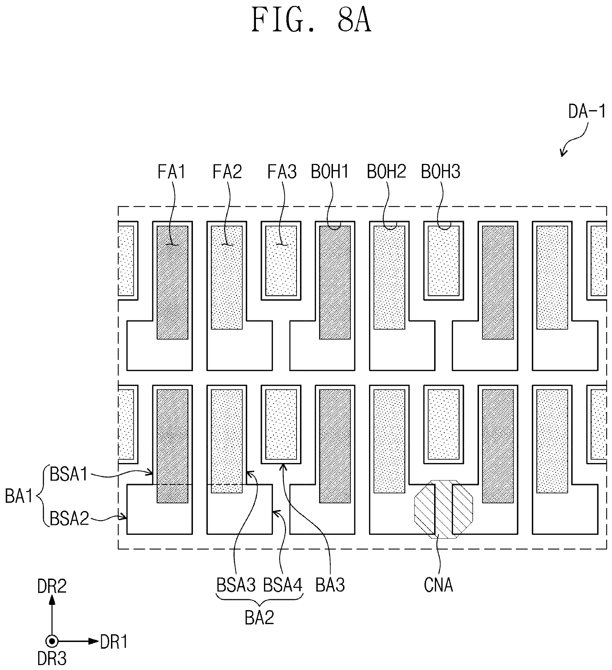

Each of FIGS. 8A to 8D is a schematic enlarged plan view of a portion of the display panel according to an embodiment of the invention. Each of FIGS. 8A to 8D illustrates the arrangement relationship between filter regions FA (FA1, FA2, and FA3) and bank regions BA (BA1, BA2, and BA3) in a display region DA-1, DA-2, DA-3, or DA-4 according to another embodiment of the invention, which is different from the display region DA according to an embodiment of the invention, which is illustrated in FIG. 2.

Referring to FIG. 8A, the display region DA-1 according to an embodiment of the invention may have a shape in which filter regions FA1, FA2, FA3 and bank regions BA1, BA2, BA3 are inverted vertically compared to the display region DA of FIG. 2. For example, in the display region DA of FIG. 2, the first sub-region BSA1 of the first bank region BA1 may be disposed in a lower area in the second direction DR2, and the second sub-region BSA2 thereof may be disposed in an upper area in the second direction DR2, but in the display region DA-1 according to an embodiment of the invention, the first sub-region BSA1 may be disposed in an upper area in the second direction DR2, and the second sub-region BSA2 may be disposed in a lower area in the second direction DR2. In the display region DA-1 according to an embodiment of the invention, the third sub-region BSA3 may be disposed in an upper area in the second direction DR2, and the fourth sub-region BSA4 may be disposed in a lower area in the second direction DR2. Corresponding to the shapes of the bank regions BA1, BA2, and BA3 that are inverted vertically, the filter regions FA1, FA2, and FA3 and the connection region CNA may also be inverted vertically compared to the embodiment of FIG. 2.

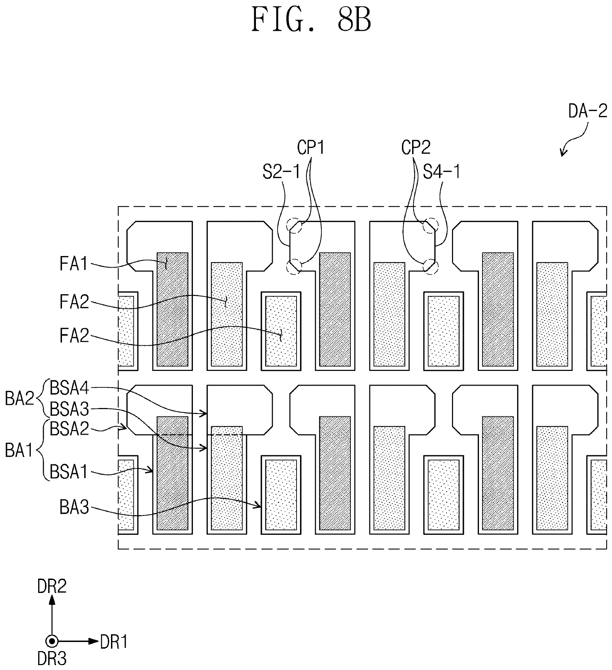

Referring to FIG. 8B, in the display region DA-2 according to an embodiment of the invention, each of the first bank region BA1 and the second bank region BA2 may include a chamfered portion. In the first bank region BA1, the second sub-region BSA2 may include a first chamfered portion CP1. In the second bank region BA2, the fourth sub-region BSA4 may include a second chamfered portion CP2. The first chamfered portion CP1 may have a shape recessed toward the inside of the second sub-region BSA2 from the (2-1)-th side S2-1. The second chamfered portion CP2 may have a shape recessed toward the inside of the fourth sub-region BSA4 from the (4-1)-th side S4-1.

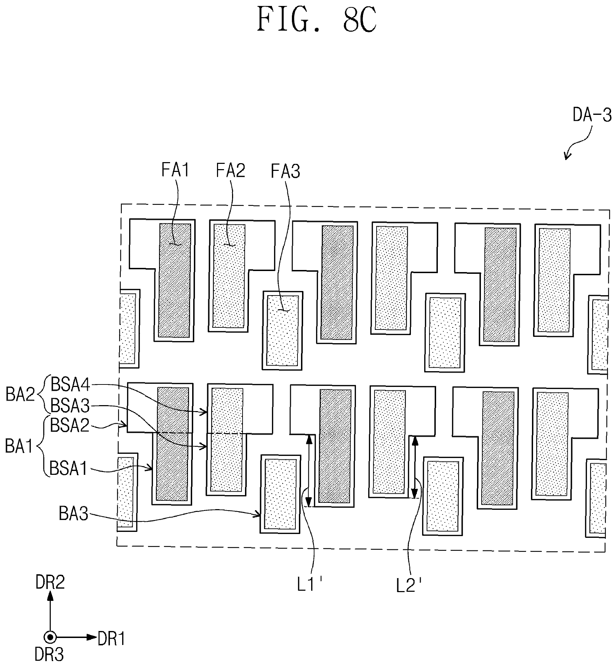

Referring to FIG. 8C, in the display region DA-3 according to an embodiment of the invention, compared to the display region DA of FIG. 2, the length of the second bank region BA2 in the second direction DR2 may be shorter than the length of the first bank region BA1. In an embodiment of the invention, a second length L2' of the third sub-region BSA3 in the second direction DR2 may be shorter than a first length L1' of the first sub-region BSA1.

In the display region DA-3 according to an embodiment of the invention, the first bank region BA1, the second bank region BA2, and the third bank region BA3 may respectively have lengths corresponding to the lengths of the corresponding filter regions FA1, FA2, and FA3 in the second direction DR2. For example, the first bank region BA1 may have a length corresponding to the length of the first filter region FA1, the second bank region BA2 may have a length corresponding to the length of the second filter region FA2, and the third bank region BA3 may have a length corresponding to the length of the third filter region FA3.

In the display region DA-3, the length of the first filter region FA1 in the second direction DR2 may be greater than the length of the second filter region FA2 in the second direction DR2. The length of the second filter region FA2 in the second direction DR2 may be greater than the length of the third filter region FA3 in the second direction DR2. Accordingly, the length of the first bank region BA1 in the second direction DR2 may be greater than the length of the second bank region BA2 in the second direction DR2, and the length of the second bank region BA2 in the second direction DR2 may be greater than the length of the third bank region BA3 in the second direction DR2.

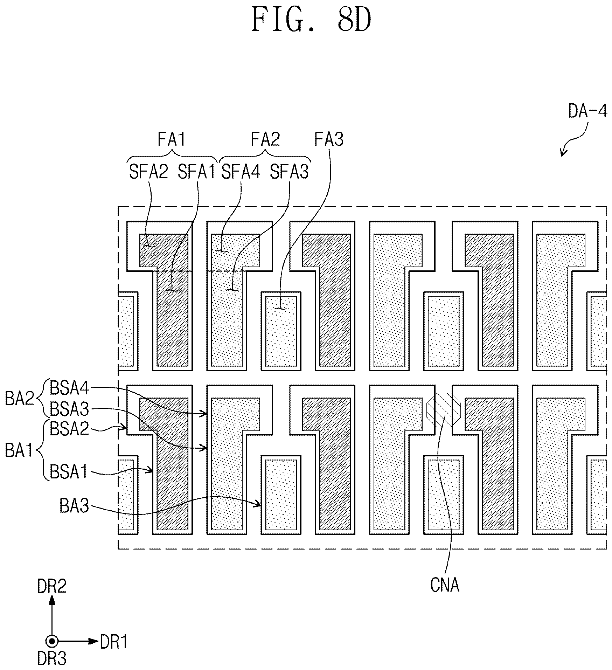

Referring to FIG. 8D, in the display region DA-4 according to an embodiment of the invention, the first filter region FA1 and the second filter region FA2 among the filter regions FA1, FA2, and FA3 may have shapes in which the widths of portions thereof are widened so as to respectively correspond to the first bank region BA1 and the second bank region BA2. In an embodiment of the invention, the first filter region FA1 may include a first sub-filter region SFA1 overlapping the first sub-region BSA1 and a second sub-filter region SFA2 overlapping the second sub-region BSA2. The width of the second sub-filter region SFA2 in the first direction DR1 may be greater than the width of the first sub-filter region SFA1 in the first direction DR1. The second filter region FA2 may include a third sub-filter region SFA3 overlapping the third sub-region BSA3 and a fourth sub-filter region SFA4 overlapping the fourth sub-region BSA4. The width of the fourth sub-filter region SFA4 in the first direction DR1 may be greater than the width of the third sub-filter region SFA3 in the first direction DR1.

Although the first filter region FA1 and the second filter region FA2 have the second sub-filter region SFA2 and the fourth sub-filter region SFA4, which have been widened, the connection region CNA may be provided to non-overlap each of the filter regions FA1, FA2, and FA3.

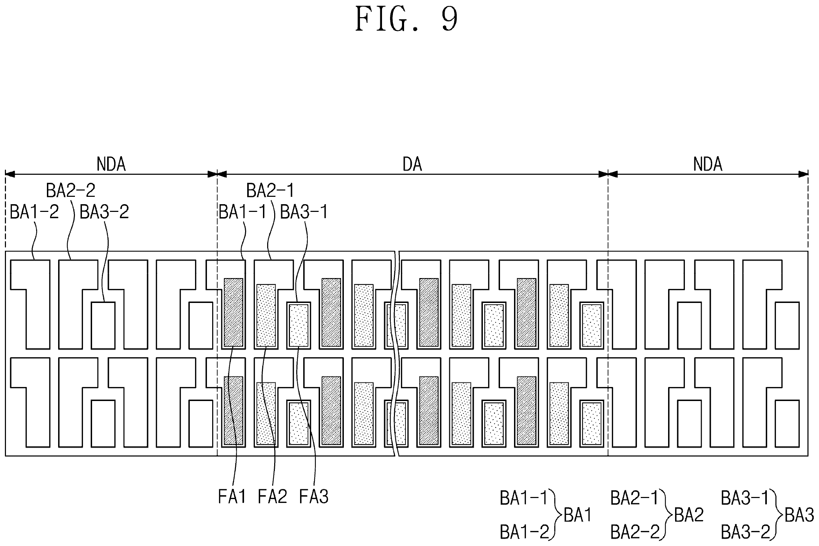

FIG. 9 is a schematic enlarged plan view of a portion of the display panel according to an embodiment of the invention. FIG. 9 illustrates the arrangement relationship between filter regions FA1, FA2, and FA3 and bank regions BA1, BA2, and BA3 in a portion of each of the display region DA and the non-display region NDA.

Referring to FIG. 9, each of the bank regions BA1, BA2, and BA3 may be provided not only in the display region DA but also in at least a portion of the non-display region NDA. The first bank region BA1 may include a (1-1)-th bank region BA1-1 provided in the display region DA and a (1-2)-th bank region BA1-2 provided in the non-display region NDA. The above-described first light control pattern CCP-R (see FIG. 4A) may be disposed in each of the (1-1)-th bank region BA1-1 and the (1-2)-th bank region BA1-2. The second bank region BA2 may include a (2-1)-th bank region BA2-1 provided in the display region DA and a (2-2)-th bank region BA2-2 provided in the non-display region NDA. The above-described second light control pattern CCP-G (see FIG. 4A) may be disposed in each of the (2-1)-th bank region BA2-1 and the (2-2)-th bank region BA2-2. The third bank region BA3 may include a (3-1)-th bank region BA3-1 provided in the display region DA and a (3-2)-th bank region BA3-2 provided in the non-display region NDA. The above-described third light control pattern CCP-B (see FIG. 4A) may be disposed in each of the (3-1)-th bank region BA3-1 and the (3-2)-th bank region BA3-2.

Unlike the bank regions BA1, BA2, and BA3, the filter regions FA1, FA2, and FA3 may be provided in the display region DA and may not be provided in the non-display region NDA. The first filter region FA1 may overlap the (1-1)-th bank region BA1-1 and may not overlap the (1-2)-th bank region BA1-2. The second filter region FA2 may overlap the (2-1)-th bank region BA2-1 and may not overlap the (2-2)-th bank region BA2-2. The third filter region FA3 may overlap the (3-1)-th bank region BA3-1 and may not overlap the (3-2)-th bank region BA3-2.

Hereinafter, a method of manufacturing a display panel according to an embodiment of the invention will be described.

The method of manufacturing the display panel according to an embodiment of the invention may include preparing a display element layer including a light-emitting element that outputs source light and forming an optical structure layer on the light-emitting element. The forming of the optical structure layer may include forming a bank, in which first to third bank openings are formed, on the light-emitting element, patterning a photoresist material in the third bank opening to form a third light control pattern, and respectively forming a first light control pattern and a second light control pattern in the first bank opening and the second bank opening through an inkjet process. The contents of the first bank opening, the second bank opening, the third bank opening, and the bank regions defined by them, which are described above with reference to FIGS. 1A to 9, may be equally applied to the contents of the same, which will be described from now on.

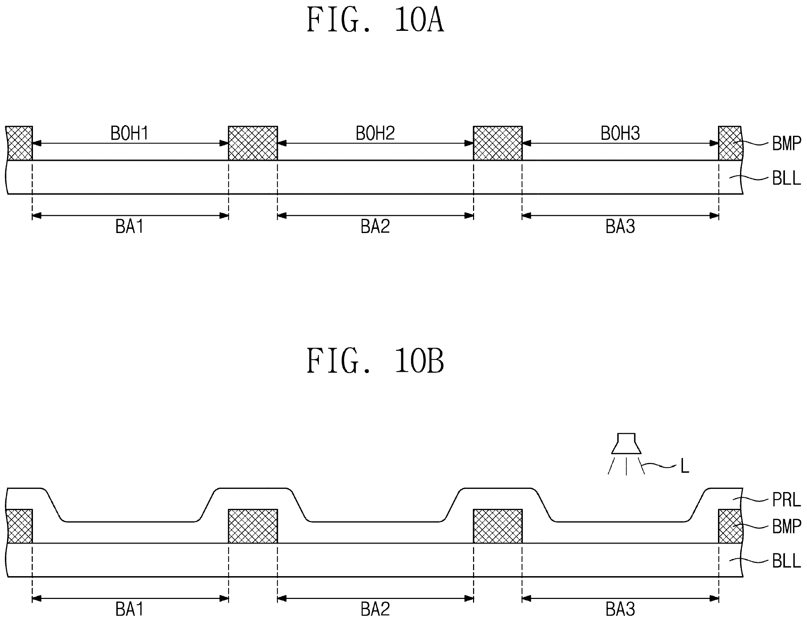

FIGS. 10A to 10D are schematic cross-sectional views illustrating some steps of a method of manufacturing a display panel according to an embodiment of the invention. FIGS. 10A to 10D briefly illustrate some steps of forming an optical structure layer in the method of manufacturing the display panel according to an embodiment of the invention.

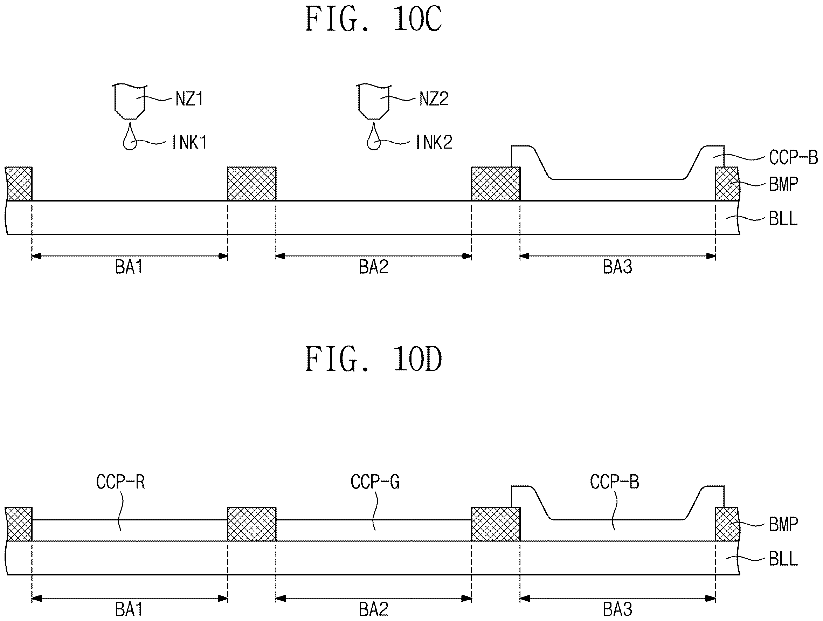

Referring to FIG. 10A, the method of manufacturing the display panel according to an embodiment of the invention may include forming a bank BMP in which a first bank opening BOH1, a second bank opening BOH2, and a third bank opening BOH3 are formed. The bank BMP may be formed on a base member BLL. The base member BLL may provide a base surface on which the bank BMP and the light control patterns CCP-R, CCP-G, and CCP-B (see FIG. 10D) are formed. For example, in case that the display panel DP illustrated in FIG. 4A is manufactured, the base member BLL may be a second barrier layer CAP2, and in case that the display panel DP-1 illustrated in FIG. 4B is manufactured, the base member BLL may be a first barrier layer CAP1.

Referring to FIGS. 10B and 10C, the method of manufacturing the display panel according to an embodiment of the invention may include applying a photoresist material PRL inside at least the third bank opening BOH3 and patterning the photoresist material PRL to form a third light control pattern CCP-B. As illustrated in FIG. 10B, the photoresist material PRL may be provided not only inside the third bank opening BOH3 but also inside the first bank opening BOH1 and the second bank opening BOH2 and may be also provided on the bank BMP. For example, the photoresist material PRL may be provided on the entire base member BLL, and after an exposure process to provide light L, an uncured portion may be removed to form the third light control pattern CCP-B. In the patterning of the photoresist material PRL, a separate photomask may be provided to perform an exposure process on only a portion of the photoresist material PRL. FIG. 10B illustrates, as an example, a negative photoresist that is cured by irradiating light L on the photoresist material PRL corresponding to the third bank opening BOH3, but the embodiment of the invention is not limited thereto, and the photoresist material PRL may be a positive photoresist, and light may be irradiated onto a portion of the photoresist material PRL except for the third bank opening BOH3.

Referring to FIGS. 10C and 10D, the method of manufacturing the display panel according to an embodiment of the invention may include forming the first light control pattern CCP-R and the second light control pattern CCP-G in the first bank opening BOH1 and the second bank opening BOH2, respectively, through an inkjet process. The first light control pattern CCP-R may be formed by providing a first ink INK1 inside the first bank opening BOH1 through a first nozzle NZ1. The second light control pattern CCP-G may be formed by providing a second ink INK2 inside the second bank opening BOH2 through a second nozzle NZ2. The first ink INK1 and the second ink INK2 respectively forming the first light control pattern CCP-R and the second light control pattern CCP-G may include quantum dots.

An inkjet impact point on which the first ink INK1 is impacted (or provided) through the first nozzle NZ1 may be the second sub-region BSA2 described above in FIG. 6A and the like. An inkjet impact point on which the second ink INK2 is impacted through the second nozzle NZ2 may be the fourth sub-region BSA4 described above in FIG. 6A and the like. In the method of manufacturing the display panel according to an embodiment of the invention, since the inkjet processes of the first ink INK1 and the second ink INK2 are performed through each of the second sub-region BSA2 and the fourth sub-region BSA4 having a wide width, the process efficiency of forming the first light control pattern CCP-R and the second light control pattern CCP-G may be improved.

According to an embodiment of the invention, as the bank opening regions provided in the light control layer include the sub-regions respectively corresponding to the pixel regions having a small width, it is possible to implement high resolution, and as other sub-regions of the bank opening regions are formed to have a large width for an inkjet process, it is possible to secure an inkjet process impact region, thus being able to improve the process efficiency of manufacturing the display panel.

The above description is an example of technical features of the invention, and those skilled in the art to which the invention pertains will be able to make various modifications and variations. Thus, the embodiments of the invention described above may be implemented separately or in combination with each other

## Claims

1. A display panel (DP) comprising:
a display element layer (DP-LED) including a light-emitting element (LED) that outputs source light; and
an optical structure layer (OSL) that is disposed on the light-emitting element (LED) and transmits the source light or converts the source light into light of a different wavelength, wherein
the optical structure layer (OSL) includes:
a light control layer (CCL) disposed above the light-emitting element (LED) and including a bank (BMP) including a first bank opening (BOH1) and a first light control pattern (CCP-R) disposed in the first bank opening (BOH1); and
a color filter layer (CFL) disposed above the light control layer (CCL) and including a first color filter (CF1) disposed in a first filter region (FA1),
a first bank region (BA1) defined by the first bank opening (BOH1) includes:
a first sub-region (BSA1) having a first width (W1) in a first direction (DR1) and a first length (L1) in a second direction (DR2) intersecting the first direction (DR1); and
a second sub-region (BSA2) having a second width (W2) in the first direction (DR1),
the second width (W2) is greater than the first width (W1),
the first filter region (FA1) overlaps the first sub-region (BSA1) and a portion of the second sub-region (BSA2),
a width (W-F1) of the first filter region (FA1) in the first direction (DR1) is smaller than or substantially equal to the first width (W1), and
a length (L-F1) of the first filter region (FA1) in the second direction (DR2) is greater than or substantially equal to the first length (L1).

2. The display panel (DP) of claim 1, wherein
the bank (BMP) further comprises a second bank opening (BOH2) spaced apart from the first bank opening (BOH1) and a third bank opening (BOH3) spaced apart from each of the first bank opening (BOH1) and the second bank opening (BOH2), and
the light control layer (CCL) further comprises a second light control pattern (CCP-G) disposed in the second bank opening (BOH2) and a third light control pattern (CCP-B) disposed in the third bank opening (BOH3).

3. The display panel (DP) of claim 2, wherein
a second bank region (BA2) defined by the second bank opening (BOH2) includes:
a third sub-region (BSA3) having a third width (W3) in the first direction (DR1) and a second length (L2) in the second direction (DR2); and
a fourth sub-region (BSA4) having a fourth width (W4) in the first direction (DR1),
the fourth width (W4) is larger than the third width (W3).

4. The display panel (DP) of claim 3, wherein
a third bank region (BA3) is defined by the third bank opening (BOH3), and
widths (W1, W3, W5) of the first sub-region (BSA1), the third sub-region (BSA3), and the third bank region (BA3) in the first direction (DR1) are substantially equal to each other.

5. The display panel (DP) of claim 4, wherein
the first bank region (BA1), the second bank region (BA2), and the third bank region (BA3) are sequentially arranged in the first direction (DR1),
the first sub-region (BSA1) and the third sub-region (BSA3) are spaced apart from each other by a first separation distance (d1) in the first direction (DR1),
the third sub-region (BSA3) and the third bank region (BA3) are spaced apart from each other by a second separation distance (d2) in the first direction (DR1), and
the first separation distance (d1) and the second separation distance (d2) are substantially equal to each other.

6. The display panel (DP) of at least one of claims 1 to 5, wherein the color filter layer (CFL) further comprises:
a second color filter (CF2) disposed in a second filter region (FA2) spaced apart from the first filter region (FA1); and
a third color filter (CF3) disposed in a third filter region (FA3) spaced apart from the first filter region (FA1) and the second filter region (FA2).

7. The display panel (DP) of claim 3 and 6, wherein
the second filter region (FA2) overlaps the third sub-region (BSA3) and a portion of the fourth sub-region (BSA4),
a width (W-F2) of the second filter region (FA2) in the first direction (DR1) is smaller than or substantially equal to the third width (W3), and
a length (L-F2) of the second filter region (FA2) in the second direction (DR2) is greater than or substantially equal to the second length (L2).

8. The display panel (DP) of claim 6 or 7, wherein
widths (W-F1, W-F2, W-F3) of the first filter region (FA1), the second filter region (FA2), and the third filter region (FA3) in the first direction (DR1) are substantially equal to each other,
a length (L-F1) of the first filter region (FA1) in the second direction (DR2) is greater than a length (L-F2) of the second filter region (FA2) in the second direction (DR2), and
a length (L-F2) of the second filter region (FA2) in the second direction (DR2) is greater than a length (L-F3) of the third filter region (FA3) in the second direction (DR2).

9. The display panel (DP) of at least one of claims 3 to 8, wherein the second length (L2) is shorter than the first length (L1).

10. The display panel (DP) of claim 2, wherein
a third bank region (BA3) is defined by the third bank opening (BOH3), and
the third bank region (BA3) has a rectangular shape on a plane.

11. The display panel (DP) of claim 10, wherein
a second bank region (BA2) is defined by the second bank opening (BOH2), and
a length of the third bank region (BA3) in the second direction (DR2) is shorter than a length of each of the first bank region (BA1) and the second bank region (BA2) in the second direction (DR2).

12. The display panel (DP) of at least one of claims 1 to 11, wherein
the first light control pattern (CCP-R) includes a first quantum dot that converts the source light into light of a first wavelength, and
the second light control pattern (CCP-G) includes a second quantum dot that converts the source light into light of a second wavelength.

13. The display panel (DP) of at least one of claims 2 to 12, wherein the third light control pattern (CCP-G) comprises a photosensitive resin.

14. The display panel (DP) of at least one of claims 1 to 13, further comprising:
a circuit element layer (DP-CL) including a pixel circuit electrically connected to the light-emitting element (LED), wherein
the light-emitting element (LED) comprises:
a first electrode (EL1) disposed on the circuit element layer (DP-CL);
an intermediate layer disposed on the first electrode (EL1) and including a light-emitting layer (EML); and
a second electrode (EL2) disposed on the intermediate layer,
the display element layer (DP-LED) further comprises an auxiliary electrode (SE) disposed on the circuit element layer (DP-CL) and electrically connected to the second electrode (EL2), and
at least a portion of a connection region (CNA) in which the auxiliary electrode (SE) is disposed overlaps the second sub-region (BSA2) on a plane.

15. The display panel (DP) of at least one of claims 1 to 14, wherein
the first sub-region (BSA1) comprises a (1-1)-th side (S1-1) and a (1-2)-th side (S1-2) extending in the second direction (DR2) and spaced apart from each other in the first direction (DR1),
the second sub-region (BSA2) comprises a (2-1)-th side (S2-1) and a (2-2)-th side (S2-2) extending in the second direction (DR2) and spaced apart from each other in the first direction (DR1), and
the (1-2)-th side (S1-2) and the (2-2)-th side (S2-2) are aligned with each other on a same straight line in the second direction (DR2).

16. The display panel (DP) of claim 15, wherein the second sub-region (BSA2) comprises a first chamfered portion (CP1) recessed toward an inside of the second sub-region (BSA2) from the (2-1)-th side (S2-1) of the second sub-region (BSA2).

17. The display panel (DP) of at least one of claims 1 to 16, wherein
the first filter region (FA1) comprises:
a first sub-filter region (SFA1) overlapping the first sub-region (BSA1); and
a second sub-filter region (SFA2) overlapping the second sub-region (BSA2), and
a width of the second sub-filter region (SFA2) in the first direction (DR1) is greater than a width of the first sub-filter region (SFA1) in the first direction (DR1).

18. The display panel (DP) of at least one of claims 1 to 17, wherein
the display element layer (DP-LED) is divided into a display region (DA) in which the light-emitting element (LED) is disposed and a non-display region (NDA) surrounding at least a portion of the display region (DA); and
the first bank region (BA1) comprises:
a (1-1)-th bank region (BA1-1) disposed in the display region (DA); and
a (1-2)-th bank region (BA1-2) disposed in the non-display region (NDA).

19. A method for manufacturing a display panel (DP), the method comprising:
preparing a display element layer (DP-LED) including a light-emitting element (LED) that outputs source light; and
forming an optical structure layer (OSL) on the light-emitting element (LED), wherein
the forming of the optical structure layer (OSL) comprises:
forming a bank (BMP) in which a first bank opening (BOH1), a second bank opening (BOH2), and a third bank opening (BOH3) are formed above the light-emitting element (LED);
patterning a photoresist material (PRL) in the third bank opening (BOH3) to form a third light control pattern (CCP-B); and
forming each of a first light control pattern (CCP-R) and a second light control pattern (CCP-G) through an inkjet process in each of the first bank opening (BOH1) and the second bank opening (BOH2),
a first bank region (BA1) defined by the first bank opening (BOH1) comprises a first sub-region (BSA1) having a first width (W1) in a first direction (DR1) and a second sub-region (BSA2) having a second width (W2) in the first direction (DR1),
a second bank region (BA2) defined by the second bank opening (BOH2) comprises a third sub-region (BSA3) having a third width (W3) in the first direction (DR1) and a fourth sub-region having a fourth width (W4) in the first direction (DR1),
the second width (W2) is greater than the first width (W1), and
the fourth width (W4) is greater than the third width (W3).
